# EUROPEAN PATENT APPLICATION

(11) **EP 4 668 273 A1**
(43) Date of publication of application: **24.12.2025**
(21) Application number: 24756637.5
(22) Date of filing: 30.01.2024
(51) Int. Cl.: G11C 11/16

(54) **STORAGE DEVICE, ELECTRONIC APPARATUS, AND METHOD FOR CONTROLLING STORAGE DEVICE**

(30) Priority: 16.02.2023 JP 2023022551
(71) Applicant: Sony Semiconductor Solutions Corporation, Atsugi-shi, Kanagawa 243-0014 (JP)
(72) Inventor: SAKAI, Lui, Atsugi-shi, Kanagawa 243-0014 (JP); HIGO, Yutaka, Atsugi-shi, Kanagawa 243-0014 (JP); YUASA, Shinji, Tsukuba-shi, Ibaraki 305-8560 (JP); MATSUMOTO, Rie, Tsukuba-shi, Ibaraki 305-8560 (JP); IMAMURA, Hiroshi, Tsukuba-shi, Ibaraki 305-8560 (JP); NOZAKI, Takayuki, Tsukuba-shi, Ibaraki 305-8560 (JP); HOSOMI, Masanori, Atsugi-shi, Kanagawa 243-0014 (JP); HIRAGA, Keizo, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/002724
(87) International publication number: WO 2024/171786

(57) **Abstract**

A storage device according to one aspect of the present disclosure includes: a magnetoresistive element having a variable resistance value; a selection element connected to the magnetoresistive element; and a write circuit that includes a load resistance circuit having a variable resistance value and applies a voltage to the magnetoresistive element via the load resistance circuit.

## Description

### Field

The present disclosure relates to a storage device, electronic equipment, and a method of controlling the storage device. Background

The state of a magnetoresistive random access memory (MRAM) using a magnetoresistive element is maintained by the magnetization state of a ferromagnetic substance, so that the MRAM has non-volatility in which data is held even when power is turned off. Examples of the MRAM include a VC-MRAM using voltage-controlled magnetic anisotropy (VCMA). For example, Patent Literature 1 discloses a technique of reversing magnetization by applying a pulse voltage to a magnetoresistive element having a VCMA effect. In Patent Literature 1, initial read is executed as a first procedure after the start of write.

### Citation List

### Patent Literature

Patent Literature 1: JP 2018-92696 A Non Patent Literature
Non Patent Literature 1: Y. C. Wu et al., "Deterministic and field-free voltage-controlled MRAM for high performance and low power applications", 2020 IEEE Symposium on VLSI Technology, July 16, 2020

### Summary

### Technical Problem

Unfortunately, in the above-described technique of Patent Literature 1, initial read increases a processing time of the entire write processing. Thus, omission of the initial read is desired. If the initial read is omitted, however, erroneous write occurs, and data write accuracy is deteriorated. Furthermore, in the above-described technique of Patent Literature 1, it is difficult to appropriately control a pulse width necessary for magnetization reversing in a pulse voltage, and it is difficult to apply the pulse voltage to the magnetoresistive element with high accuracy. The data write accuracy is thus deteriorated.

Therefore, the present disclosure provides a storage device, electronic equipment, and a method of controlling the storage device capable of improving data write accuracy.

### Solution to Problem

A storage device according to one aspect of the present disclosure includes: a magnetoresistive element having a variable resistance value; a selection element connected to the magnetoresistive element; and a write circuit that includes a load resistance circuit having a variable resistance value and applies a voltage to the magnetoresistive element via the load resistance circuit.

Electronic equipment according to one aspect of the present disclosure includes a storage device that stores data, wherein the storage device includes: a magnetoresistive element having a variable resistance value; a selection element connected to the magnetoresistive element; and a write circuit that includes a load resistance circuit having a variable resistance value and applies a voltage to the magnetoresistive element via the load resistance circuit.

A method of controlling a storage device according to one aspect of the present disclosure includes controlling a storage device including: a magnetoresistive element having a variable resistance value; and a selection element connected to the magnetoresistive element, wherein a write circuit applies a voltage to the magnetoresistive element via a load resistance circuit having a variable resistance value.

### Brief Description of Drawings

FIG. 1 illustrates a configuration example of a storage device according to a first embodiment.
FIG. 2 illustrates a configuration example of a memory cell according to the first embodiment.
FIG. 3 illustrates a configuration example of various circuits including a load resistance circuit according to the first embodiment.
FIG. 4 is a flowchart illustrating write processing according to the first embodiment.
FIG. 5 is a timing chart illustrating write processing to a high resistance according to the first embodiment.
FIG. 6 is a timing chart illustrating write processing to a low resistance according to the first embodiment.
FIG. 7 is a graph illustrating the voltage dependency of the perpendicular magnetic anisotropy (constant) of a magnetoresistive element according to the first embodiment.
FIG. 8 illustrates voltage division in a case where a voltage is applied to the magnetoresistive element via fixed resistor R1 or R2 according to the first embodiment.
FIG. 9 illustrates the behavior of a magnetization vector caused by voltage application via the fixed resistor R1 according to the first embodiment.
FIG. 10 illustrates the behavior of the magnetization vector caused by voltage application via the fixed resistor R2 according to the first embodiment.
FIG. 11 illustrates a configuration example of a storage device according to Variation 1 of the first embodiment.
FIG. 12 illustrates a configuration example of a memory cell array of a storage device according to Variation 2 of the first embodiment.
FIG. 13 is a flowchart illustrating write processing according to a second embodiment.
FIG. 14 is a timing chart illustrating write processing to a high resistance according to the second embodiment.
FIG. 15 is a timing chart illustrating write processing to a low resistance according to the second embodiment.
FIG. 16 is a flowchart illustrating write processing according to Variation 1 of the second embodiment.
FIG. 17 is a flowchart illustrating write processing according to Variation 2 of the second embodiment.
FIG. 18 illustrates a configuration example of a load resistance circuit according to a third embodiment.
FIG. 19 is a timing chart illustrating write processing to a high resistance according to the third embodiment.
FIG. 20 is a timing chart illustrating write processing to a low resistance according to the third embodiment.
FIG. 21 is a flowchart illustrating write processing according to a fourth embodiment.
FIG. 22 is a timing chart illustrating write processing to a high resistance according to the fourth embodiment.
FIG. 23 is a timing chart illustrating write processing to a low resistance according to the fourth embodiment.
FIG. 24 illustrates a configuration example of a load resistance circuit of a storage device according to a fifth embodiment.
FIG. 25 is a flowchart illustrating write processing according to the fifth embodiment.
FIG. 26 is a timing chart illustrating write processing according to the fifth embodiment.
FIG. 27 is a graph illustrating the characteristics of a magnetoresistive element according to the fifth embodiment.
FIG. 28 is a graph illustrating the voltage dependency of the perpendicular magnetic anisotropy (constant) of a magnetoresistive element according to the fifth embodiment.
FIG. 29 illustrates voltage division in a case where a voltage is applied to the magnetoresistive element via the fixed resistor R4 according to the fifth embodiment.
FIG. 30 illustrates a voltage change of the magnetoresistive element according to the fifth embodiment.
FIG. 31 illustrates a simulation result in a case where a pulse voltage is applied to the magnetoresistive element in a high resistance state or a low resistance state according to the fifth embodiment via the fixed resistor R4.
FIG. 32 is a flowchart illustrating write processing according to Variation 1 of the fifth embodiment.
FIG. 33 is a flowchart illustrating write processing according to a sixth embodiment.
FIG. 34 is a timing chart illustrating write processing according to the sixth embodiment.
FIG. 35 illustrates a voltage change of a magnetoresistive element according to the sixth embodiment.
FIG. 36 is a flowchart illustrating write processing according to a seventh embodiment.
FIG. 37 is a timing chart illustrating write processing according to the seventh embodiment.
FIG. 38 illustrates a voltage change of a magnetoresistive element according to the seventh embodiment.
FIG. 39 is a timing chart illustrating write processing according to an eighth embodiment.
FIG. 40 illustrates an example of a schematic configuration of an imaging device.
FIG. 41 illustrates an example of a schematic configuration of a distance measuring device.

### Description of Embodiments

Embodiments of the present disclosure will be described in detail below with reference to the drawings. The embodiments also include examples and variations. Note that a device, equipment, a method, and the like according to the present disclosure are not limited by the embodiments of the present disclosure. Furthermore, in the following embodiments, duplicate description will be omitted by basically attaching the same reference signs to the same parts.

One or a plurality of embodiments below can each be implemented independently. In contrast, at least a part of the plurality of embodiments below may be appropriately combined with at least a part of other embodiments to be implemented. The plurality of embodiments can include different novel features. Therefore, the embodiments can contribute to achieving different objects or solving different problems, and exhibit different effects. Note that the effects in the embodiments are merely examples and not limitations. Other effects may be exhibited.

The present disclosure will be described in the following item order.
1. First Embodiment
   1-1. Configuration Example of Storage Device
   1-2. Configuration Example of Memory Cell
   1-3. Configuration Example of Various Circuits Including Load Resistance Circuit
   1-4. Example of Write Processing
   1-5. Example of Timing Chart of Write Processing
   1-6. Example of Voltage Dependency of Perpendicular Magnetic Anisotropy of Magnetoresistive Element
   1-7. Example of Voltage Division Through Load Resistor
   1-8. Example of Behavior of Magnetization Vector Caused by Voltage Application via Load Resistor
   1-9. Variation 1 of Storage Device
   1-10. Variation 2 of Storage Device
2. Second Embodiment
   2-1. Example of Write Processing
   2-2. Example of Timing Chart of Write Processing
   2-3. Variation 1 of Write Processing
   2-4. Variation 2 of Write Processing
3. Third Embodiment
   3-1. Configuration Example of Load Resistance Circuit
   3-2. Example of Timing Chart of Write Processing
4. Fourth Embodiment
   4-1. Processing Example of Write Processing
   4-2. Example of Timing Chart of Write Processing
5. Fifth Embodiment
   5-1. Configuration Example of Storage Device
   5-2. Processing Example of Write Processing
   5-3. Example of Timing Chart of Write Processing
   5-4. Example of Characteristics of Magnetoresistive Element
   5-5. Example of Voltage Dependency of Perpendicular Magnetic Anisotropy of Magnetoresistive Element
   5-6. Example of Voltage Division Through Load Resistor
   5-7. Example of Voltage Change of Magnetoresistive Element
   5-8. Example of Simulation Result of Write
   5-9. Variation 1 of Write Processing
6. Sixth Embodiment
   6-1. Processing Example of Write Processing
   6-2. Example of Timing Chart of Write Processing
   6-3. Example of Voltage Change of Magnetoresistive Element
7. Seventh Embodiment
   7-1. Processing Example of Write Processing
   7-2. Example of Timing Chart of Write Processing
   7-3. Example of Voltage Change of Magnetoresistive Element
8. Eighth Embodiment
   8-1. Example of Timing Chart of Write Processing
9. Functions/Effects According to Each Embodiment
10. Other Embodiments
11. Configuration Example of Electronic equipment
   11-1. Imaging Device
   11-2. Distance Measuring Device
12. Appendix

<1. First Embodiment>

### <1-1. Configuration Example of Storage Device>

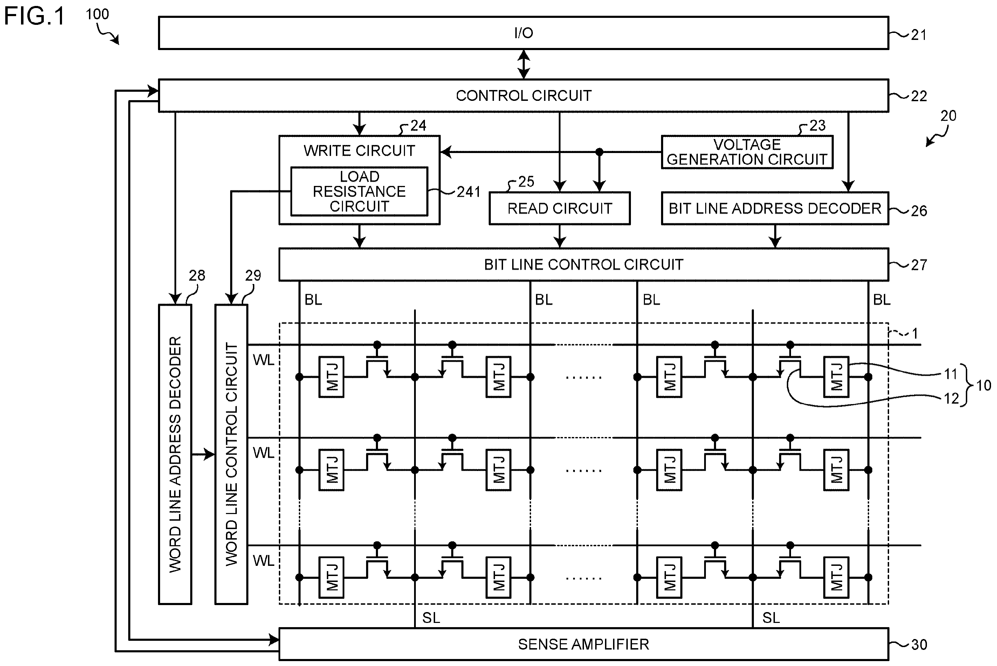

A configuration example of a storage device 100 according to a first embodiment will be described with reference to FIG. 1. FIG. 1 illustrates the configuration example of the storage device 100 according to the first embodiment.

As illustrated in FIG. 1, the storage device 100 includes a memory cell array 1. The storage device 100 is an example of a storage device that holds data by a magnetization direction of a magnetic substance.

The memory cell array 1 includes a plurality of two-dimensionally arranged memory cells 10. These memory cells 10 are connected to bit lines BL, source lines SL, and word lines WL. For example, the plurality of word lines WL is arranged so as to extend in a row direction. The plurality of bit lines BL and the plurality of source lines SL are arranged so as to extend in a column direction. The bit lines BL, the source lines SL, and the word lines WL function as control lines.

Each of the memory cells 10 includes a magnetoresistive element (magnetoresistive effect element) 11 and a selection element 12. A magnetoresistive element such as a magnetic tunnel junction (MTJ) can be used as the magnetoresistive element 11. The selection element 12 is connected to one end of the magnetoresistive element 11, and controls application of a voltage, a current, or the like to the magnetoresistive element 11. For example, various transistors can be used as the selection element 12.

Note that each of the memory cells 10 shares one source line SL with another memory cell 10 in every two lines in the column direction. That is, each of the memory cells 10 arranged in two lines in the column direction is connected to two bit lines BL and one source line SL (2BL/1SL).

The storage device 100 includes a peripheral circuit 20 in addition to the memory cell array 1. In an example of FIG. 1, the peripheral circuit 20 includes an I/O 21, a control circuit 22, a voltage generation circuit 23, a write circuit 24, a read circuit 25, a bit line address decoder 26, a bit line control circuit 27, a word line address decoder 28, a word line control circuit 29, and a sense amplifier 30. The bit line control circuit 27 is connected to the bit lines BL. The word line control circuit 29 is connected to the word lines WL. The sense amplifier 30 is connected to the source lines SL. Since such a basic configuration of a memory is known, the basic configuration will be briefly described.

The I/O 21 enables exchange of a command related to read and write of data, an address of a memory cell 10 to be accessed, data, and the like between an external circuit (e.g., CPU) of the storage device 100 and the control circuit 22 of the storage device 100.

The control circuit 22 performs control related to write and read of data to and from the memory cell 10 in accordance with a command.

The voltage generation circuit 23 generates a voltage (e.g., pulse voltage) to be used for read and write of data from and to the memory cell 10. Note that a voltage necessary for a circuit operation is separately given.

The write circuit 24 controls a voltage and a current (e.g., pulse voltage and pulse current) used for data write to the memory cell 10. The write circuit 24 functions as a write unit. The write circuit 24 includes a load resistance circuit 241. Details of the load resistance circuit 241 will be described later.

The read circuit 25 controls a voltage (e.g., pulse voltage) used for read of data from the memory cell 10, specifically, detection of the resistance value of the magnetoresistive element 11. The read circuit 25 functions as a read unit.

The bit line address decoder 26 obtains an address of a bit line BL corresponding to an address received by the above-described I/O 21.

The bit line control circuit 27 selectively controls the bit line BL corresponding to the address of the bit line address decoder 26. For example, write of data to the memory cell 10 performed by the write circuit 24 and read of data from the memory cell 10 performed by the read circuit 25 are performed via the bit line control circuit 27.

The word line address decoder 28 obtains an address of a word line WL corresponding to the address received by the above-described I/O 21.

The word line control circuit 29 selectively controls the word line WL corresponding to the address of the word line address decoder 28.

The sense amplifier 30 detects data read from the memory cell 10 by the read circuit 25, specifically, the resistance value of the magnetoresistive element 11.

### <1-2. Configuration Example of Memory Cell>

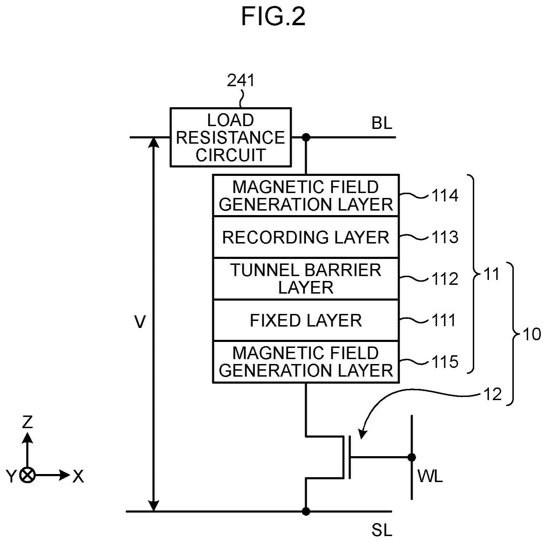

A configuration example of the memory cell 10 according to the first embodiment will be described with reference to FIG. 2. FIG. 2 illustrates the configuration example of the memory cell 10 according to the first embodiment.

As illustrated in FIG. 2, the memory cell 10 includes the magnetoresistive element 11 and the selection element 12. The magnetoresistive element 11 and the selection element 12 are connected in series between a bit line BL and a source line SL. In an example of FIG. 2, a voltage that can be applied to the memory cell 10 and the load resistance circuit 241 is referred to as a voltage V. The voltage V is controlled by the write circuit 24, the read circuit 25 (see FIG. 1), or the like, and applied to the memory cell 10 via the load resistance circuit 241. That is, the voltage V is applied to the memory cell 10 including the load resistance circuit 241. Note that the resistance value of the selection element 12 is extremely smaller than those of the magnetoresistive element 11 and the load resistance circuit 241.

The magnetoresistive element 11 is, for example, an MTJ element having a VCMA effect, and has a stacked structure. In the example of FIG. 2, an XYZ coordinate system for the magnetoresistive element 11 is illustrated for convenience of description. An X-axis direction and a Y-axis direction correspond to a layer plane direction. The X-axis direction, the Y-axis direction, and an XY plane direction may be referred to as horizontal directions. A Z-axis direction corresponds to a direction perpendicular to the layer plane direction (stacked direction). The Z-axis direction may be referred to as a perpendicular direction.

The magnetoresistive element 11 includes a fixed layer 111, a tunnel barrier layer 112, a recording layer 113, and a plurality of magnetic field generation layers 114 and 115. In this example, the magnetic field generation layer 115, the fixed layer 111, the tunnel barrier layer 112, the recording layer 113, and the magnetic field generation layer 114 are stacked in that order in a Z-axis positive direction. Various known materials may be used as materials for the layers. Only one of the magnetic field generation layers 114 and 115 may be provided.

The fixed layer 111 is a magnetic layer whose magnetization direction is fixed, and is also referred to as a reference layer or the like. The magnetization of the fixed layer 111 is fixed in the Z-axis positive direction, for example.

The tunnel barrier layer 112 is a nonmagnetic layer provided between the fixed layer 111 and the recording layer 113.

The recording layer 113 is a magnetic layer whose magnetization direction changes, and is also referred to as a free layer or the like. The magnetization of the recording layer 113 changes between the Z-axis positive direction and a Z-axis negative direction, for example.

Note that the fixed layer 111 and the recording layer 113 may be arranged in a manner opposite to that in the example of FIG. 2. In that case, the recording layer 113, the tunnel barrier layer 112, and the fixed layer 111 are stacked in this order in the Z-axis positive direction.

The magnetic field generation layer 114 generates a horizontal magnetic field. That is, the memory cell 10 is configured such that the recording layer 113 is placed in a magnetic field (horizontal magnetic field) in the layer plane direction (XY plane direction). In the example of FIG. 2, the magnetic field generation layer 114 is provided on the opposite side of the tunnel barrier layer 112 with the recording layer 113 being sandwiched therebetween.

Note that the magnetic field generation layer 114 may be provided on the opposite side of the tunnel barrier layer 112 with the fixed layer 111 being sandwiched therebetween. Furthermore, a method using other than the magnetic field generation layer 114 may be used to generate the horizontal magnetic field. For example, a magnetic field may be generated by forming a magnet layer above (side of Z-axis positive direction) or below (side of Z-axis negative direction) the magnetoresistive element 11. A magnetic field may be generated by peripherally arranging a permanent magnet.

The magnetic field generation layer 115 generates a perpendicular magnetic field. That is, the memory cell 10 is configured such that the recording layer 113 is also placed in a magnetic field (perpendicular magnetic field) in a direction perpendicular to the layer plane direction (Z-axis direction). In the example of FIG. 2, the magnetic field generation layer 115 is provided on the opposite side of the tunnel barrier layer 112 with the fixed layer 111 being sandwiched therebetween.

Note that the magnetic field generation layer 115 is provided on the opposite side of the tunnel barrier layer 112 with the recording layer 113 being sandwiched therebetween. Furthermore, a method using other than the magnetic field generation layer 115 may be used to generate the perpendicular magnetic field. For example, a magnetic field may be generated by forming a magnet layer above (side of Z-axis positive direction) or below (side of Z-axis negative direction) the magnetoresistive element 11. A magnetic field may be generated by peripherally arranging a permanent magnet.

The selection element 12 is, for example, a field effect transistor (FET). One of a drain terminal and a source terminal of the selection element 12 is connected to the magnetoresistive element 11. The other of the drain terminal and the source terminal of the selection element 12 is connected to the source line SL. A gate terminal of the selection element 12 is connected to a word line WL. When a voltage signal from the word line WL is applied to a gate of the selection element 12 and the selection element 12 is turned on (drain and source are brought into conductive state), the magnetoresistive element 11 is connected to the bit line BL and the source line SL, and the voltage V is applied to the magnetoresistive element 11 and the like.

Data (e.g., 0 or 1) is written to the memory cell 10 by switching a resistance state (resistance value R) of the magnetoresistive element 11 between a low resistance state (low resistance value R_{L}) and a high resistance state (high resistance value R_{H}). In the low resistance state, the magnetization of the fixed layer 111 is parallel with that of the recording layer 113. In the high resistance state, the magnetization of the fixed layer 111 is antiparallel with that of the recording layer 113. For example, the resistance state of the magnetoresistive element 11 is switched between the low resistance state and the high resistance state by reversing the magnetization direction of the recording layer 113 between the Z-axis positive direction and the Z-axis negative direction. For example, data corresponding to the low resistance state is 0, and data corresponding to the high resistance state is 1. The magnetoresistive element 11 is, for example, an MTJ element capable of reversing the magnetization of the recording layer 113 by using the VCMA effect.

Note that, according to the above-described magnetoresistive element 11, not only a magnetic field in the horizontal direction but a magnetic field in the perpendicular direction is used. The magnetic field in the perpendicular direction causes a change in magnetic field energy to a magnetization component m_{Z} (-1 to 1) of the recording layer 113 to have asymmetry. Oscillation in the magnetization direction can be inhibited and the magnetization direction can be reversed in the Z-axis negative direction by making design such that the magnetic field energy is minimized within a range where the magnetization component m_{Z} is negative (-1 ≤ magnetization component m_{Z} < 0), that is, at a place where the magnetization of the recording layer 113 is close to the Z-axis negative direction. The resistance value R of the magnetoresistive element 11 can be set to the high resistance value R_{H} without controlling the pulse width of the voltage V with high accuracy.

As described above, the magnetoresistive element 11 has a basic sandwich structure in which a nonmagnetic thin film of an insulator is sandwiched between two magnetic layers including magnetic substance thin films. This structure is called a magnetic tunnel junction (MTJ). Since the nonmagnetic thin film has an extremely small thickness of approximately several nanometers, a tunnel current flows when a voltage is applied to both ends of an element. A feature is that the magnitude of the tunnel current depends on the relative angle between the magnetizations of the two magnetic layers. This is called a tunnel magneto resistance (TMR) effect. In an MRAM, the magnetization of one (fixed layer 111) of the two magnetic layers is fixed, and the magnetization of the other (recording layer 113) is controlled by an external field. Examples of the external field used for the magnetization direction control include a method using voltage-controlled magnetic anisotropy (VCMA). A TMR effect is used for read of a state.

### <1-3. Configuration Example of Various Circuits Including Load Resistance Circuit>

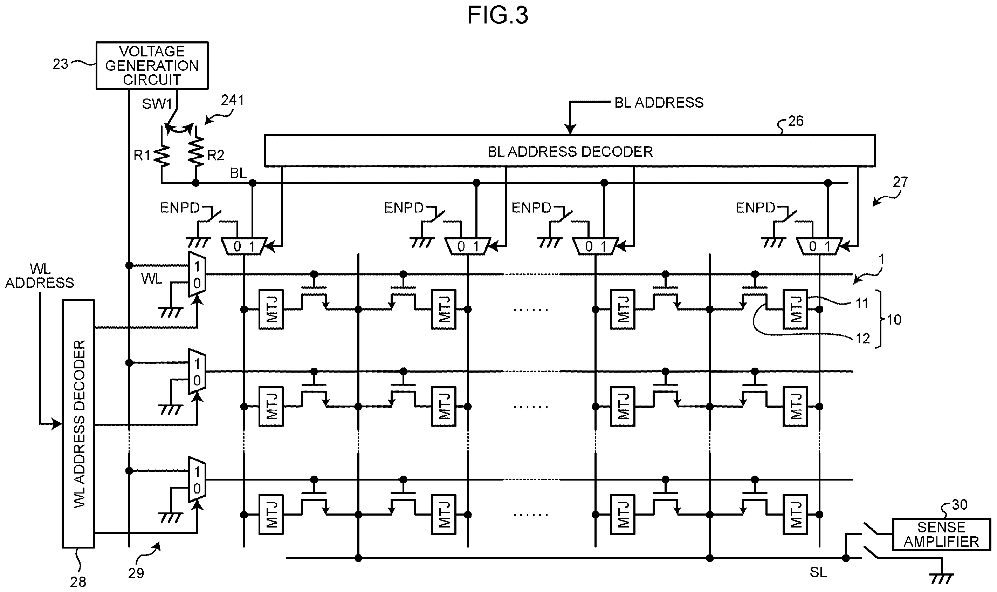

A configuration example of various circuits including the load resistance circuit 241 according to the first embodiment will be described with reference to FIG. 3. FIG. 3 illustrates the configuration example of various circuits including the load resistance circuit 241 according to the first embodiment.

As illustrated in FIG. 3, the load resistance circuit 241 includes a plurality of fixed resistors R1 and R2 and a switch SW1. The load resistance circuit 241 is provided in a wiring path between the voltage generation circuit 23 and the bit line control circuit 27.

Each of the fixed resistors R1 and R2 functions as a load resistor. The fixed resistor R1 has a resistance value smaller than that of the fixed resistor R2 (R1 < R2). The switch SW1 receives a switching signal from the control circuit 22, and switches the wiring path. For example, the switch SW1 switches between a wiring path passing through the fixed resistor R1 and a wiring path passing through the fixed resistor R2. That is, the load resistance circuit 241 can switch between the wiring paths passing through the fixed resistors R1 and R2 with the switch SW1, and can be connected to the voltage generation circuit 23 and the bit line control circuit 27.

The load resistance circuit 241 as described above switches between and uses the fixed resistors R1 and R2, and makes a resistance value variable. That is, the load resistance circuit 241 has a function of setting a plurality of different resistance values. When the resistance value of the magnetoresistive element 11 is set to the low resistance value R_{L}, that is, when write is performed to a low resistance, the load resistance circuit 241 applies the voltage V to the magnetoresistive element 11 via the fixed resistor R1. When the resistance value of the magnetoresistive element 11 is set to the high resistance value R_{H}, that is, when write is performed to a high resistance, the load resistance circuit 241 applies the voltage V to the magnetoresistive element 11 via the fixed resistor R2. The magnitude of the voltage V at the time of performing write in a case where a program is performed to a low resistance is the same as that in a case where write is performed to a high resistance.

The bit line address decoder 26 has a function of connecting (turning on) only a bit line BL of a memory cell 10 to be accessed to the voltage generation circuit 23 via the load resistance circuit 241 and disconnecting (turning off) other bit lines BL for an address regarding which an instruction is given from the control circuit 22.

The bit line control circuit 27 passes a write signal (program signal) only to the bit line BL to be accessed from control signals of the bit line address decoder 26. Note that the potential applied to a bit line BL not to be accessed can be switched to a ground potential (GND potential) or a floating potential.

The word line address decoder 28 has a function of connecting (turning on) only a word line WL of a memory cell 10 to be accessed to the voltage generation circuit 23 and disconnecting (turning off) other word lines WL for an address regarding which an instruction is given from the control circuit 22.

The word line control circuit 29 turns on the selection element 12 only to the word line WL to be accessed from control signals of the word line address decoder 28. A GND potential is applied to a word line WL not to be accessed, and the selection element 12 is turned off. A negative voltage may be used instead of the GND potential as long as the selection element 12 can be turned off.

Note that the source line SL is connected to the GND at the time of write (program), and is connected to the sense amplifier 30 at the time of read. The read is performed by detecting a current flowing through the memory cell 10 with the sense amplifier 30, for example.

### <1-4. Example of Write Processing>

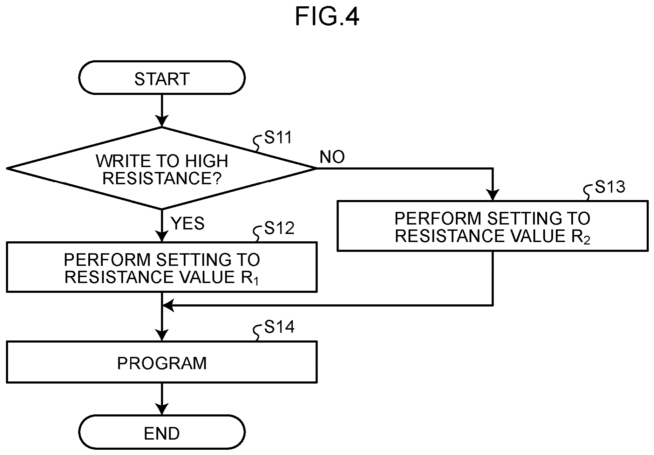

An example of write processing according to the first embodiment will be described with reference to FIG. 4. FIG. 4 is a flowchart illustrating the write processing according to the first embodiment.

The control circuit 22 (e.g., state machine of control circuit 22) controls the write processing. The flowchart is started by a write command input from the I/O 21 to the control circuit 22 and input of write data. Note that, for convenience, data corresponding to a low resistance is 0, and data corresponding to a high resistance is 1.

As illustrated in FIG. 4, in Step S11, whether or not write to a high resistance is performed, that is, whether or not the write data is 1 is determined. When it is determined that the write data is 1 (Yes in Step S11), a load resistor is set to the fixed resistor R1, that is, the resistance value of the load resistor is set to a resistance value R₁ of the fixed resistor R1 in Step S12.

In contrast, when it is not determined in Step S11 that the write data is 1 (No in Step S11), the load resistor is set to the fixed resistor R2, that is, the resistance value of the load resistor is set to a resistance value R₂ of the fixed resistor R2 in Step S13.

In Step S14, the set resistance value R₁ or R₂ is used, and a program is executed. The program refers to write for reversing the resistance state of the magnetoresistive element 11. Data is written to a target magnetoresistive element 11. The write processing then ends. The write processing refers to the entire processing associated with data recording, and includes, for example, the setting and program of a load resistor.

Note that, in the above-described program, the write circuit 24 applies a predetermined voltage V to the magnetoresistive element 11 via the fixed resistor R1 or R2 of the load resistance circuit 241. This sets the resistance value R of the magnetoresistive element 11 to the high resistance value R_{H} or the low resistance value R_{L}.

### <1-5. Example of Timing Chart of Write Processing>

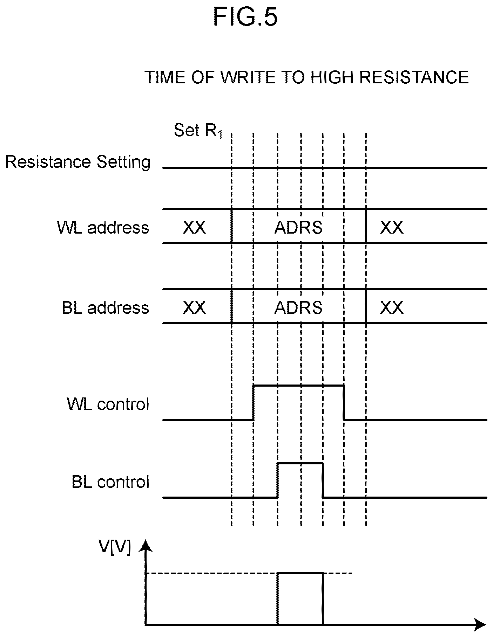

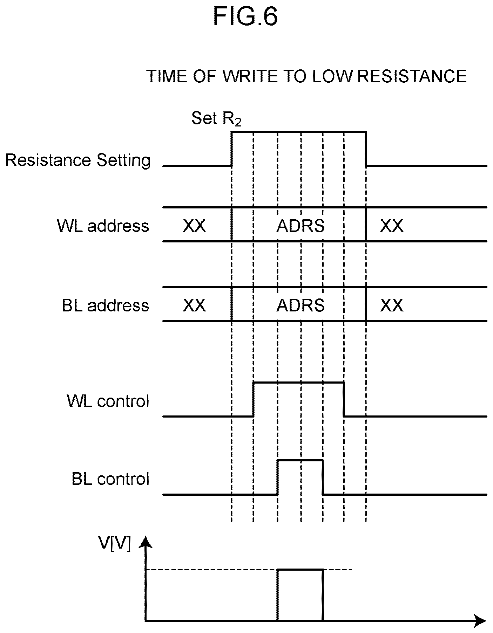

An example of a timing chart of the write processing according to the first embodiment will be described with reference to FIGS. 5 and 6. FIG. 5 is a timing chart illustrating write processing to a high resistance according to the first embodiment. FIG. 6 is a timing chart illustrating write processing to a low resistance according to the first embodiment.

In Step S12 or S13 in FIG. 4, the control circuit 22 transmits the setting of the fixed resistor R1 or R2 to the load resistance circuit 241, and transmits an address of a program target to the word line address decoder 28 and the bit line address decoder 26.

Specifically, as illustrated in FIG. 5, when a signal of resistance setting (Resistance Setting) is turned off, the control circuit 22 transmits the setting of the fixed resistor R1 to the load resistance circuit 241 (Set R1). The load resistance circuit 241 switches the switch SW1 to set a load resistor to the fixed resistor R1 in accordance with the setting transmitted from the control circuit 22.

Furthermore, the control circuit 22 transmits an address (WL address: ADRS) of the program target to the word line address decoder 28, and transmits an address (BL address: ADRS) of the program target to the bit line address decoder 26.

The word line address decoder 28 decodes the address input from the control circuit 22, and turns on the corresponding word line WL (WL control). This "on" is to connect the corresponding word line WL with the voltage generation circuit 23.

The bit line address decoder 26 decodes the address input from the control circuit 22, and turns on the corresponding bit line BL (BL control). This "on" is to connect the corresponding bit line BL with the load resistance circuit 241.

When both the word line WL and the bit line BL are turned on, the voltage V is applied only to the memory cell 10 at the corresponding address and the fixed resistor R1. The voltage V is a pulse voltage.

As illustrated in FIG. 6, when the signal of resistance setting (Resistance Setting) is turned on, the control circuit 22 transmits the setting of the resistance value R2 to the load resistance circuit 241. The load resistance circuit 241 switches the switch SW1 to set the load resistor to the fixed resistor R2 in accordance with the setting transmitted from the control circuit 22.

Although the subsequent processing is similar to the processing in FIG. 5, the load resistor is set to the fixed resistor R2. Thus, when both the word line WL and the bit line BL are turned on, the voltage V is applied only to the memory cell 10 at the corresponding address and the fixed resistor R2.

Here, the voltage V desirably has a pulse width of, for example, 0.1 ns or more and 20 ns or less. A pulse width of 0.1 ns or more reliably causes precession. A pulse width of 20 ns or less settles (stabilizes) the precession. A pulse width exceeding 20 ns causes magnetization to completely face an external magnetic field direction, thereby ending the precession.

Note that, although a voltage in write to a high resistance is the same as that in write to a low resistance, the voltage in write to a high resistance may be different from that in write to a low resistance. Furthermore, although the voltage is a pulse voltage, the voltage is not limited to a pulse voltage.

### <1-6. Example of Voltage Dependency of Perpendicular Magnetic Anisotropy of Magnetoresistive Element>

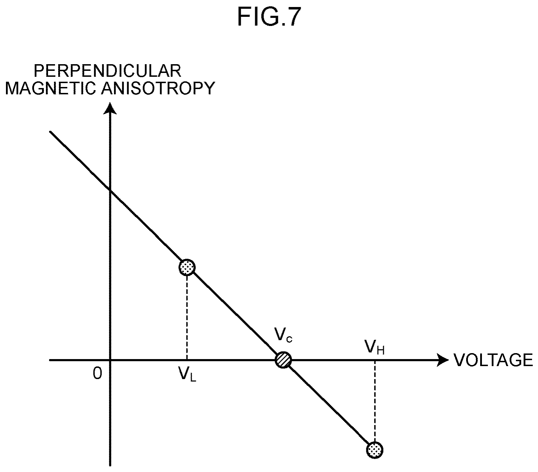

An example of the voltage dependency of the perpendicular magnetic anisotropy of the magnetoresistive element 11 according to the first embodiment will be described with reference to FIG. 7. FIG. 7 is a graph illustrating the voltage dependency of the perpendicular magnetic anisotropy (constant) of the magnetoresistive element 11 according to the first embodiment. The horizontal axis of the graph indicates the voltage V. The vertical axis of the graph indicates the perpendicular magnetic anisotropy of the recording layer 113.

As illustrated in FIG. 7, the perpendicular magnetic anisotropy is almost 0 near a voltage Vc. The perpendicular magnetic anisotropy remains at a voltage V_{L} smaller than the voltage Vc. In-plane magnetic anisotropy exists at a voltage V_{H} larger than the voltage Vc. A region with negative perpendicular magnetic anisotropy has the in-plane magnetic anisotropy. Larger perpendicular magnetic anisotropy makes the recording layer 113 more likely to be magnetized in the perpendicular direction. More specifically, positive perpendicular magnetic anisotropy makes the recording layer 113 more likely to be magnetized in the perpendicular direction (Z-axis direction). Negative perpendicular magnetic anisotropy makes the recording layer 113 more likely to be magnetized in the horizontal direction (XY plane direction).

Here, "perpendicular" refers to a z-axis direction perpendicular to the inside of an xy plane where an external magnetic field is applied. The "inside of a plane" refers to the inside of the xy plane. When the in-plane magnetic anisotropy is given, a magnetization vector rotates in the xy plane, and does not rotate in the z-axis direction, so that no reversing occurs.

### <1-7. Example of Voltage Division Through Load Resistor>

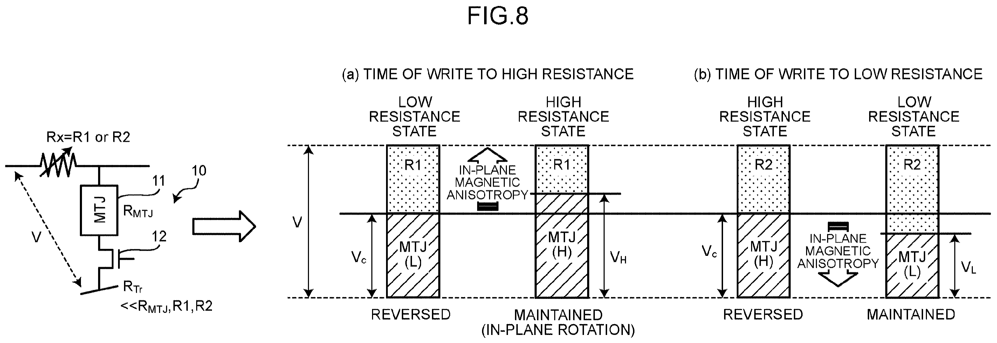

An example of voltage division through the load resistor, that is, the fixed resistor R1 or R2 according to the first embodiment will be described with reference to FIG. 8. FIG. 8 illustrates voltage division in a case where the voltage V is applied to the magnetoresistive element 11 via the fixed resistor R1 or R2 according to the first embodiment.

Here, (a) of FIG. 8 illustrates the time of write to a high resistance, and illustrates write in which a low resistance state is brought into a high resistance state and write in which a high resistance state is maintained. Then, (b) of FIG. 8 illustrates the time of write to a low resistance, and illustrates write in which a high resistance state is brought into a low resistance state and write in which a low resistance state is maintained.

As illustrated in (a) of FIG. 8, in a system in which the fixed resistor R1 is connected in series with the magnetoresistive element 11, the voltage V is assumed in which the voltage Vc is distributed to the magnetoresistive element 11 in the low resistance state. When the magnetoresistive element 11 is in a high resistance state in the same system, a voltage distributed to the fixed resistor R1 is small, and a voltage V_{H} larger than Vc is applied to the magnetoresistive element 11.

Specifically, when the voltage V is applied to the magnetoresistive element 11 in the low resistance state and the fixed resistor R1, the voltage of the magnetoresistive element 11 is the voltage Vc, so that the perpendicular magnetic anisotropy is almost 0, and reversing occurs. In contrast, when the voltage V is applied to the magnetoresistive element 11 in the high resistance state and the fixed resistor R1, the voltage of the magnetoresistive element 11 is the voltage V_{H}, so that the perpendicular magnetic anisotropy is smaller than 0, and no reversing occurs (maintained).

As illustrated in (b) of FIG. 8, in a system in which the fixed resistor R2 is connected in series with the magnetoresistive element 11, the voltage V is assumed in which the voltage Vc is distributed to the magnetoresistive element 11 in the high resistance state. When the magnetoresistive element 11 is in a low resistance state in the same system, a voltage distributed to the fixed resistor R2 is large, and a voltage V_{L} smaller than Vc is applied to the magnetoresistive element 11.

Specifically, when the voltage V is applied to the magnetoresistive element 11 in the high resistance state and the fixed resistor R2, the voltage of the magnetoresistive element 11 is the voltage Vc, so that the perpendicular magnetic anisotropy is almost 0, and reversing occurs. In contrast, when the voltage V is applied to the magnetoresistive element 11 in the low resistance state and the fixed resistor R2, the voltage of the magnetoresistive element 11 is the voltage V_{L}, so that the perpendicular magnetic anisotropy is larger than 0, and no reversing occurs (maintained).

As described above, the setting of the load resistance circuit 241 is different between a case where a program for setting the state of the magnetoresistive element 11 from the high resistance state to the low resistance state is executed and a case where a program for setting the state of the magnetoresistive element 11 from the low resistance state to the high resistance state is executed. For example, the load resistance circuit 241 uses the fixed resistor R1 when a program for setting the resistance state of the magnetoresistive element 11 from the low resistance state to the high resistance state is executed, and uses the fixed resistor R2 when a program for setting the resistance state of the magnetoresistive element 11 from the high resistance state to the low resistance state is executed.

### <1-8. Example of Behavior of Magnetization Vector Caused by Voltage Application via Load Resistor>

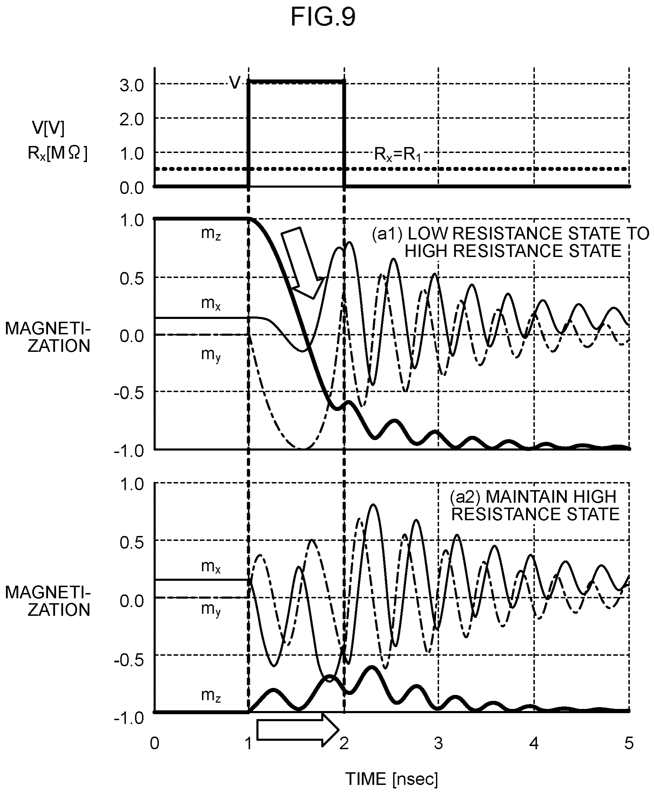

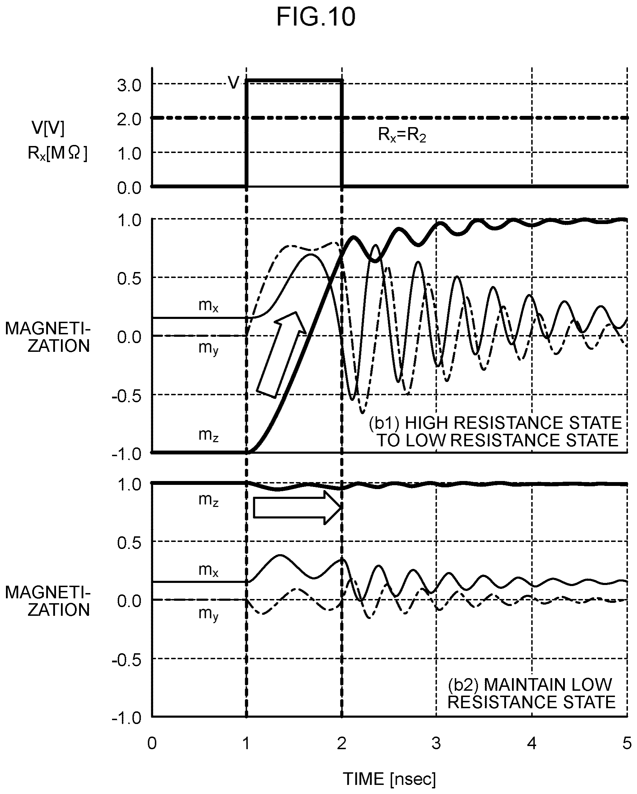

An example of the behavior of a magnetization vector caused by voltage application via the load resistor, that is, the fixed resistor R1 or R2 according to the first embodiment will be described with reference to FIGS. 9 and 10. FIG. 9 illustrates the behavior of the magnetization vector caused by voltage application via the fixed resistor R1 according to the first embodiment. FIG. 10 illustrates the behavior of the magnetization vector caused by voltage application via the fixed resistor R2 according to the first embodiment.

In examples of FIGS. 9 and 10, the magnetization vector is set as (mₓ, m_{y}, m_{z}). The magnetization vector positive in the z-axis direction (m_{z} > 0) indicates the low resistance state. The magnetization vector negative in the z-axis direction (m, < 0) indicates the high resistance state.

A graph (graph in middle stage) of (a1) and a graph (graph in lower stage) of (a2) in FIG. 9 indicate the behavior of the magnetization vector (mₓ, m_{y}, m_{z}) in a case where the voltage V is applied to the magnetoresistive element 11 via the fixed resistor R1. A graph (graph in middle stage) of (b1) and a graph (graph in lower stage) of (b2) in FIG. 10 indicate the behavior of the magnetization vector (mₓ, m_{y}, m_{z}) in a case where the voltage V is applied to the magnetoresistive element 11 via the fixed resistor R2.

In the graph of (a1) in FIG. 9, when the voltage V is applied to the magnetoresistive element 11 in the low resistance state (m_{z} > 0) and the fixed resistor R1, the magnetoresistive element 11 changes from the low resistance state (m_{z} > 0) to the high resistance state (m_{z} < 0).

In the (a2) graph in FIG. 9, when the voltage V is applied to the magnetoresistive element 11 in the high resistance state (m_{z} < 0) and the fixed resistor R1, the magnetoresistive element 11 does not change from the high resistance state (m_{z} < 0), and the high resistance state (m_{z} < 0) is maintained.

In the (b1) graph of FIG. 10, when the voltage V is applied to the magnetoresistive element 11 in the high resistance state (m_{z} < 0) and the fixed resistor R2, the magnetoresistive element 11 changes from the high resistance state (m_{z} < 0) to the low resistance state (m_{z} > 0).

In the (b2) graph in FIG. 10, when the voltage V is applied to the magnetoresistive element 11 in the low resistance state (m_{z} > 0) and the fixed resistor R2, the magnetoresistive element 11 does not change from the low resistance state (m_{z} > 0), and the low resistance state (m_{z} > 0) is maintained.

As described above, in order to bring the magnetoresistive element 11 into the low resistance state, it is sufficient if the fixed resistor R1 is set and the voltage V is applied to the magnetoresistive element 11 via the fixed resistor R1. Furthermore, in order to bring the magnetoresistive element 11 into the high resistance state, it is sufficient if the fixed resistor R2 is set and the voltage V is applied to the magnetoresistive element 11 via the fixed resistor R2. This eliminates the need for determining whether or not to perform initial read and execute a program. This makes the initial read unnecessary, so that a write time can be shortened. Moreover, power consumption can be lowered by shortening a write time. Furthermore, making initial read unnecessary does not cause erroneous write, which can improve write accuracy.

Note that, in a write method making initial read unnecessary, the gate voltage of a selection transistor serving as the selection element 12 can be switched between write from the low resistance state to the high resistance state of the magnetoresistive element 11 and write from the high resistance state to the low resistance state. Changing the gate voltage has an effect of changing the on-resistance of the selection transistor. The voltage applied to the magnetoresistive element 11 can be controlled in accordance with whether the magnetoresistive element 11 has a high resistance or a low resistance. In this case, however, since the gate voltage of the selection transistor is controlled, the control of the on-resistance of the selection transistor may be difficult, or a desired resistance value may fail to be obtained. An expected operation may fail to be achieved. This deteriorates data write accuracy. Using the load resistance circuit 241 as described above enables easy and accurate control of a load resistor on the magnetoresistive element 11, so that the expected operation can be achieved. Therefore, the data write accuracy can be improved as compared with that in the case where the gate voltage of the selection transistor is controlled.

### <1-9. Variation 1 of Storage Device>

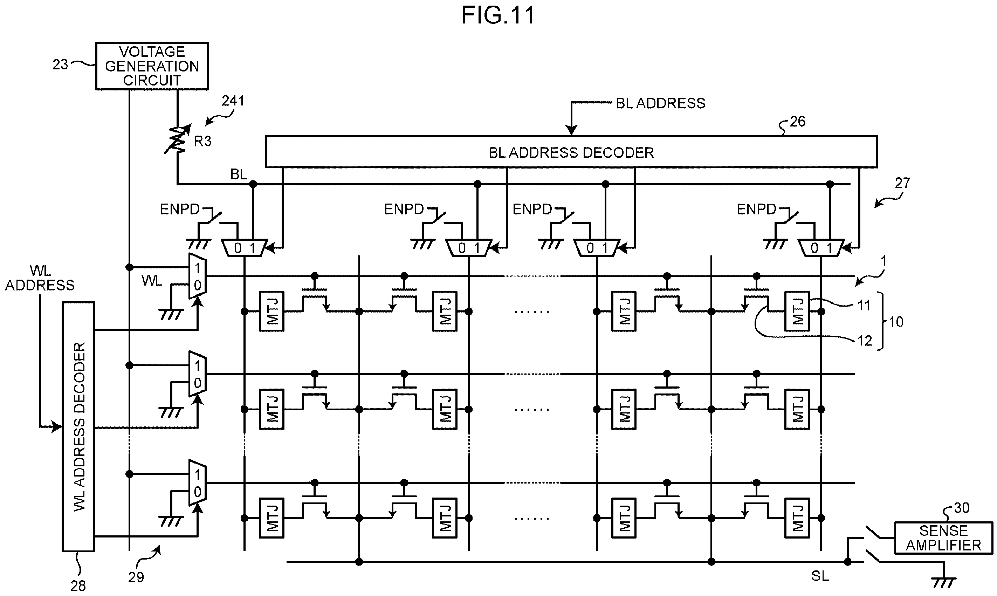

Variation 1 of the storage device 100 according to the first embodiment will be described with reference to FIG. 11. FIG. 11 illustrates a configuration example of the storage device 100 according to Variation 1 of the first embodiment. The storage device 100 according to Variation 1 is basically the same as that of the first embodiment. The difference (load resistance circuit 241) therebetween will be described here.

As illustrated in FIG. 11, the load resistance circuit 241 according to Variation 1 includes a variable resistor R3. The variable resistor R3 is a resistance having a variable resistance value. The variable resistor R3 functions as a load resistor. The load resistance circuit 241 changes the resistance value of the variable resistor R3 under the control of the control circuit 22. For example, the load resistance circuit 241 changes the resistance value of the variable resistor R3 to the resistance value R₁ or R₂ under the control of the control circuit 22. Note that other configurations, various pieces of processing, and the like are similar to those of the first embodiment described above. Effects similar to those of the first embodiment can be obtained also in Variation 1.

### <1-10. Variation 2 of Storage Device>

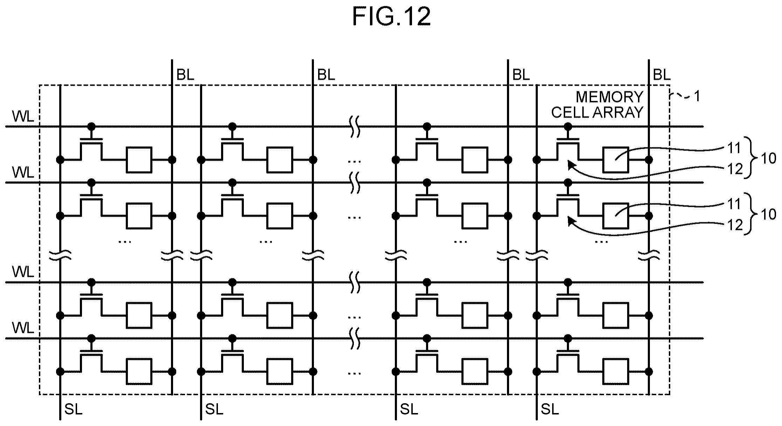

Variation 2 of the storage device 100 according to the first embodiment will be described with reference to FIG. 12. FIG. 12 illustrates a configuration example of the memory cell array 1 of the storage device 100 according to Variation 2 of the first embodiment. The storage device 100 according to Variation 2 is basically the same as that of the first embodiment. The difference (memory cell array 1) therebetween will be described here.

As illustrated in FIG. 12, in the memory cell array 1 according to Variation 2, each of the memory cells 10 has one source line SL in every line in the column direction. That is, each of the memory cells 10 arranged in one line in the column direction is connected to one bit line BL and one source line SL (1BL/1SL). Note that other configurations, various pieces of processing, and the like are similar to those of the first embodiment described above. Effects similar to those of the first embodiment can be obtained also in Variation 2.

### <2. Second Embodiment>

### <2-1. Example of Write Processing>

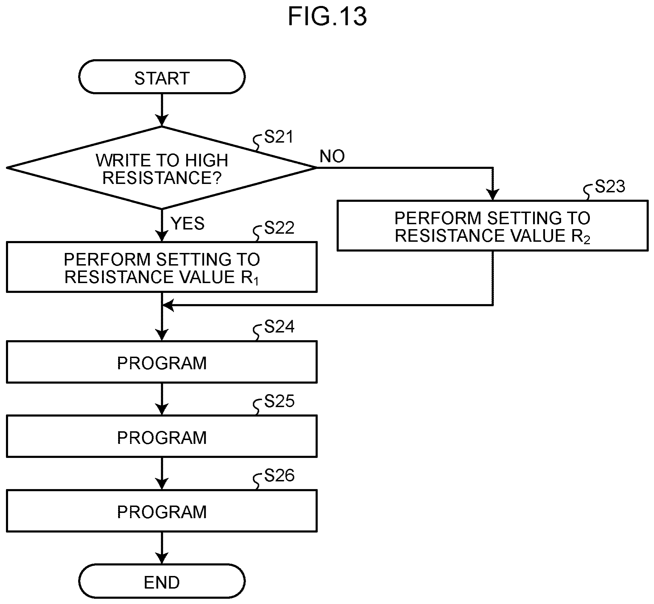

An example of write processing according to a second embodiment will be described with reference to FIG. 13. FIG. 13 is a flowchart illustrating the write processing according to the second embodiment. The second embodiment is basically the same as the first embodiment. The difference (write processing) therebetween will be described here.

Although a program (write) is executed once in the first embodiment, the program is executed a plurality of number of times in the second embodiment. As a result, even if one program fails, a write error rate, which is a failure probability of write, can be lowered by trying the program a plurality of number of times.

As illustrated in FIG. 13, in Step S21, whether or not write to a high resistance is performed, that is, whether or not the write data is 1 is determined. When it is determined that the write data is 1 (Yes in Step S21), a load resistor is set to the fixed resistor R1, that is, the resistance value of the load resistor is set to the resistance value R₁ of the fixed resistor R1 in Step S22.

In contrast, when it is not determined in Step S21 that the write data is 1 (No in Step S21), the load resistor is set to the fixed resistor R2, that is, the resistance value of the load resistor is set to the resistance value R₂ of the fixed resistor R2 in Step S23.

In Step S24, a program is executed by using the set resistance value R₁ or R₂. In Step S25, the program is similarly executed. In Step S26, the program is similarly executed. The program is repeatedly executed three times as described above, and data is written to the target magnetoresistive element 11. The write processing then ends.

Note that, in the above-described program executed three times, the write circuit 24 applies the predetermined voltage V three times to the magnetoresistive element 11 via the fixed resistor R1 or R2 of the load resistance circuit 241. This sets the resistance value R of the magnetoresistive element 11 to the high resistance value R_{H} or the low resistance value R_{L}.

In such write processing, a program is executed several times after setting the resistance value R₁ or R₂. The program may be executed any number of times. For example, when a write error rate of 1.E-6 is required with one write error rate being set as 0.01, the program is executed three times. Although being preset, the number of times the program is executed may be changed in accordance with an input operation to an external device such as an input device connected to the storage device 100, for example.

### <2-2. Example of Timing Chart of Write Processing>

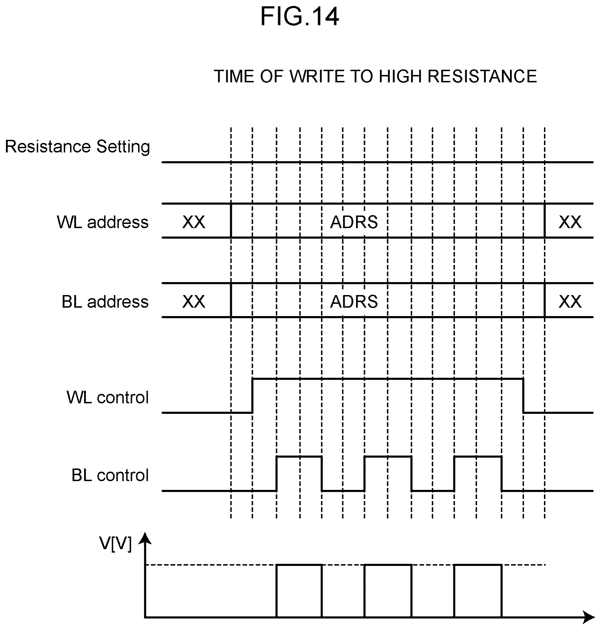

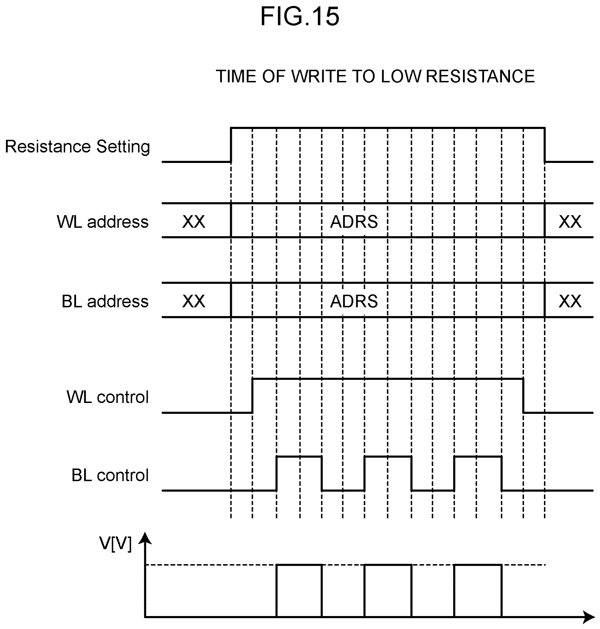

An example of a timing chart of the write processing according to the second embodiment will be described with reference to FIGS. 14 and 15. FIG. 14 is a timing chart illustrating write processing to a high resistance according to the second embodiment. FIG. 15 is a timing chart illustrating write processing to a low resistance according to the second embodiment.

Although the timing chart in FIG. 14 is basically the same as the timing chart in FIG. 5, the bit line BL is turned on three times while the word line WL is kept on in FIG. 14. This causes the voltage V to be applied three times only to the memory cell 10 at the corresponding address and the fixed resistor R1. That is, the program is executed three times. This can lower the write error rate.

Although the timing chart in FIG. 15 is basically the same as the timing chart in FIG. 6, the bit line BL is turned on three times while the word line WL is kept on in FIG. 15. This causes the voltage V to be applied three times only to the memory cell 10 at the corresponding address and the fixed resistor R2. That is, the program is executed three times. This can lower the write error rate.

Note that the voltage V has a constant pulse width, this is not a limitation. The voltage V may have a pulse width different for each application of the voltage V. The optimum write pulse width may vary between magnetoresistive elements 11 in the memory cell array 1. The write error rate can be reduced by performing write a plurality of number of times with different pulse widths.

### <2-3. Variation 1 of Write Processing>

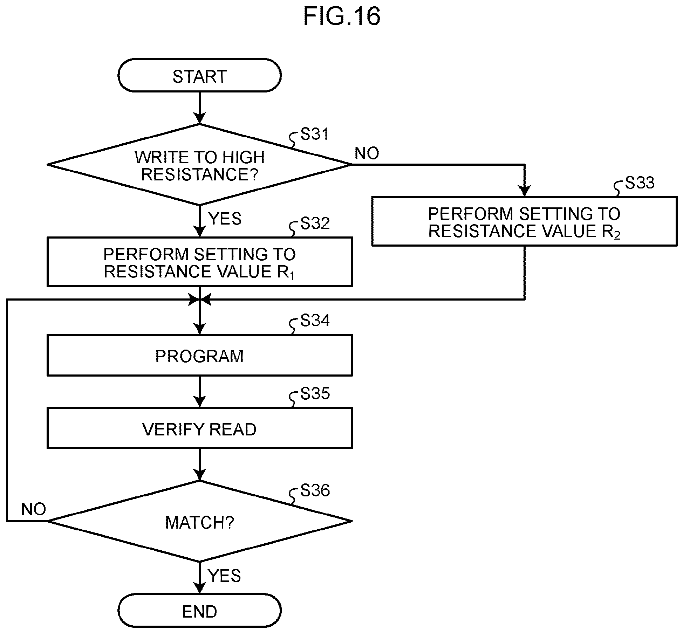

Variation 1 of the write processing according to the second embodiment will be described with reference to FIG. 16. FIG. 16 is a flowchart illustrating the write processing according to Variation 1 of the second embodiment. Variation 1 is basically the same as the first embodiment. The difference (write processing) therebetween will be described here.

In Variation 1, verify read may be performed each time a program is performed. For example, when power consumption necessary for read is lower than power consumption necessary for the program, excessive executions of the program can be reduced, so that the power consumption can be reduced.

As illustrated in FIG. 16, in Step S31, whether or not write to a high resistance is performed, that is, whether or not the write data is 1 is determined. When it is determined that the write data is 1 (Yes in Step S31), a load resistor is set to the fixed resistor R1, that is, the resistance value of the load resistor is set to the resistance value R₁ of the fixed resistor R1 in Step S32.

In contrast, when it is not determined in Step S31 that the write data is 1 (No in Step S31), the load resistor is set to the fixed resistor R2, that is, the resistance value of the load resistor is set to the resistance value R₂ of the fixed resistor R2 in Step S33.

In Step S34, the set resistance value R₁ or R₂ is used, and a program is executed. This causes data to be written to the target magnetoresistive element 11.

Note that, in the above-described program, the write circuit 24 applies a predetermined voltage V to the magnetoresistive element 11 via the fixed resistor R1 or R2 of the load resistance circuit 241. This sets the resistance value R of the magnetoresistive element 11 to the high resistance value R_{H} or the low resistance value R_{L}.

In Step S35, verify read is executed. In Step S36, whether or not read data matches an expected value is determined. The read data is read from the target magnetoresistive element 11 by the verify read. The expected value is a value of the write data.

When it is not determined in Step S36 that the read write data matches the expected value (No in Step S36), the processing returns to Step S34. In contrast, when it is determined that the read write data matches the expected value (Yes in Step S36), the write processing ends.

In such write processing, the program is executed after setting the resistance value R₁ or R₂, and the program is repeatedly executed until write succeeds. This enables excessive executions of the program and thus power consumption to be reduced while inhibiting the write error rate.

### <2-4. Variation 2 of Write Processing>

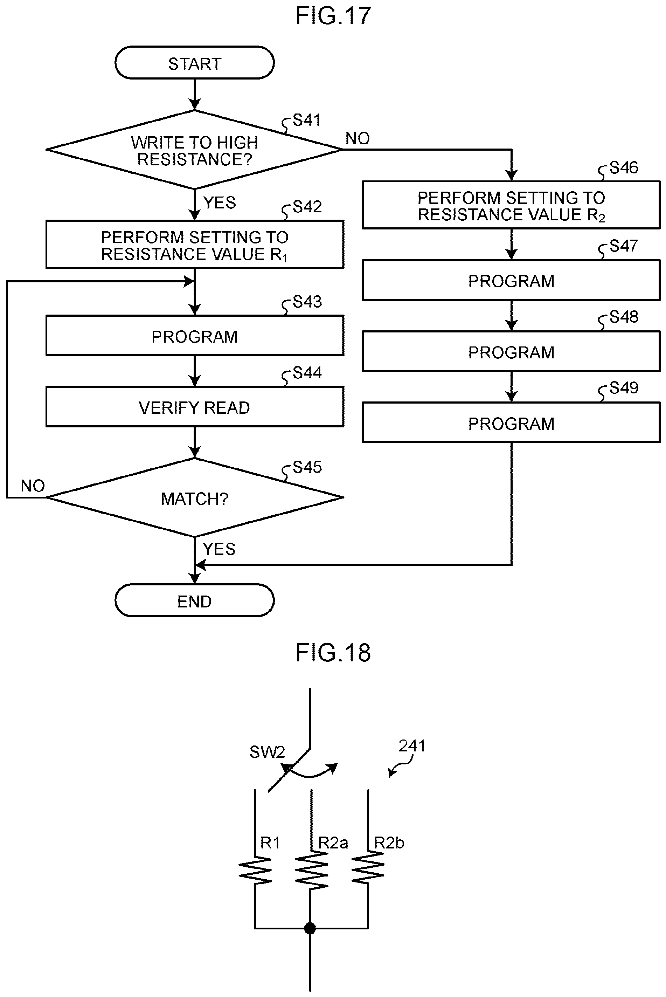

Variation 2 of the write processing according to the second embodiment will be described with reference to FIG. 17. FIG. 17 is a flowchart illustrating the write processing according to Variation 2 of the second embodiment. Variation 2 is basically the same as the first embodiment. The difference (write processing) therebetween will be described here.

In Variation 2, verification is performed each time a program (write) is executed on the side of the fixed resistor R1 (resistance value R₁), and the program is repeatedly executed on the side of the fixed resistor R2 (resistance value R₂). For example, in a case of a high probability that a high resistance state cannot be maintained due to voltage application to the magnetoresistive element 11 and the fixed resistor R1, excessive executions of the program can be reduced by performing verification, and the probability of occurrence of unexpected reversing can be lowered.

As illustrated in FIG. 17, in Step S41, whether or not write to a high resistance is performed, that is, whether or not the write data is 1 is determined. When it is determined that the write data is 1 (Yes in Step S41), a load resistor is set to the fixed resistor R1, that is, the resistance value of the load resistor is set to the resistance value R₁ of the fixed resistor R1 in Step S42.

In Step S43, the set resistance value R₁ is used, and a program is executed. This causes data to be written to the target magnetoresistive element 11.

Note that, in the above-described program, the write circuit 24 applies the predetermined voltage V to the magnetoresistive element 11 via the fixed resistor R1 of the load resistance circuit 241. This sets the resistance value R of the magnetoresistive element 11 to the high resistance value R_{H}.

In Step S44, verify read is executed. In Step S45, whether or not read data matches an expected value is determined. The read data is read from the target magnetoresistive element 11 by the verify read. The expected value is a value of the write data.

When it is not determined in Step S45 that the read write data matches the expected value (No in Step S45), the processing returns to Step S43. In contrast, when it is determined that the read write data matches the expected value (Yes in Step S45), the write processing ends.

In contrast, when it is not determined in Step S41 that the write data is 1 (No in Step S41), the load resistor is set to the fixed resistor R2, that is, the resistance value is set to the resistance value R₂ in Step S46.

In Step S47, a program is executed by using the set resistance value R₂. In Step S48, the program is similarly executed. In Step S49, the program is similarly executed. The program is repeatedly executed three times as described above, and data is written to the target magnetoresistive element 11. The write processing then ends.

Note that, in the above-described program executed three times, the write circuit 24 applies the predetermined voltage V to the magnetoresistive element 11 three times via the fixed resistor R2 of the load resistance circuit 241. This sets the resistance value R of the magnetoresistive element 11 to the low resistance value R_{L}.

In such write processing, verify read is performed after executing a program from the low resistance state to the high resistance state. When the read data matches the expected value, the program ends. When the read data does not match the expected value, the program is repeated. Furthermore, the program from the high resistance state to the low resistance state is executed a plurality of number of times without executing the verify read. Excessive executions of the program can be reduced and the probability of occurrence of unexpected reversing can be lowered by performing verify read while inhibiting the write error rate.

### <3. Third Embodiment>

### <3-1. Configuration Example of Load Resistance Circuit>

A configuration example of the load resistance circuit 241 according to a third embodiment will be described with reference to FIG. 18. FIG. 18 illustrates the configuration example of the load resistance circuit 241 according to the third embodiment. The third embodiment is basically the same as the first embodiment. The difference (load resistance circuit 241 and write processing) therebetween will be described here.

In the first embodiment (or second embodiment), settings of the load resistors (fixed resistors R1 and R2) are provided for each of a case where a program is executed from the high resistance state to the low resistance state and a case where the program is executed from the low resistance state to the high resistance state. In contrast, in the third embodiment, a plurality of settings of load resistors (fixed resistors R1, R2a, and R2b) for executing the program from the high resistance state to the low resistance state is provided, and the load resistors are switched between in the middle of the pulse of the voltage V.

As illustrated in FIG. 18, the load resistance circuit 241 includes a plurality of fixed resistors R1, R2a, and R2b and a switch SW2. As in the first embodiment, the load resistance circuit 241 is provided in a wiring path between the voltage generation circuit 23 and the bit line control circuit 27.

Each of the fixed resistors R1, R2a, and R2b functions as a load resistor. The fixed resistor R1 has a resistance value smaller than that of the fixed resistor R2b, and the fixed resistor R2a has a resistance value larger than that of the fixed resistor R2b (R1 < R2b < R2a). The switch SW2 receives a switching signal from the control circuit 22, and switches the wiring path. For example, the switch SW2 switches between a wiring path passing through the fixed resistor R1, a wiring path passing through the fixed resistor R2a, and a wiring path passing through the fixed resistor R2b. That is, the load resistance circuit 241 can switch between the wiring paths passing through the fixed resistors R1, R2a, and R2b with the switch SW2, and can be connected to the voltage generation circuit 23 and the bit line control circuit 27.

The load resistance circuit 241 as described above switches between and uses the fixed resistors R1, R2a, and R2b, and makes a resistance value variable. That is, the load resistance circuit 241 has a function of setting a plurality of different resistance values. Furthermore, the load resistance circuit 241 has a plurality of settings for executing a program from the high resistance state to the low resistance state. For example, the load resistance circuit 241 divides a pulse voltage into the first half and the latter half, and makes the value of a load resistor in the latter half smaller than that in the first half. Specifically, when a program is executed for setting the state of the magnetoresistive element 11 from the high resistance state to the low resistance state, the load resistance circuit 241 sets the load resistor to the fixed resistor R2a in the pulse first half of the pulse voltage, and sets the load resistor to the fixed resistor R2b in the pulse latter half of the pulse voltage.

Note that the load resistance circuit 241 may use the variable resistor R3 instead of the fixed resistors R1, R2a, and R2b. For example, the load resistance circuit 241 can set the fixed resistors R1, R2a, and R2b by using the variable resistor R3. Furthermore, the magnitude relation between the fixed resistors R1, R2a, and R2b is not limited to the above-described magnitude relation.

### <3-2. Example of Timing Chart of Write Processing>

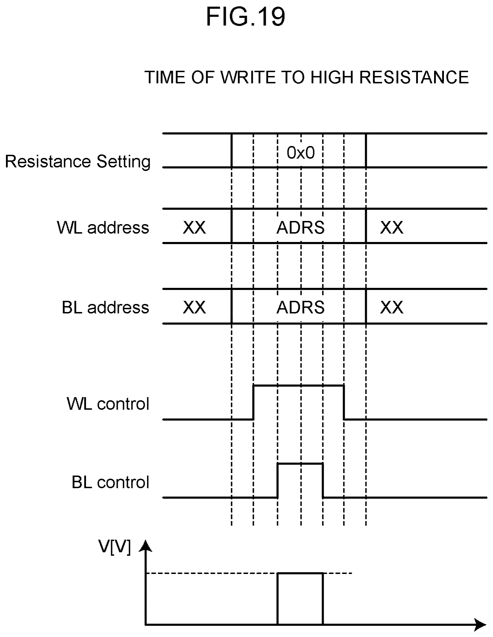

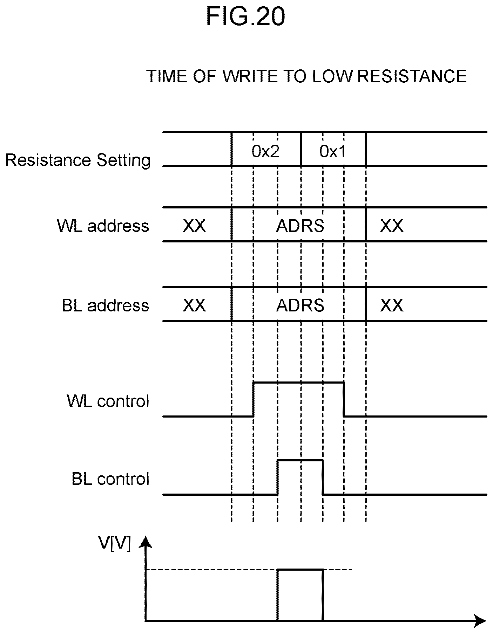

An example of a timing chart of the write processing according to the third embodiment will be described with reference to FIGS. 19 and 20. FIG. 19 is a timing chart illustrating write processing to a high resistance according to the third embodiment. FIG. 20 is a timing chart illustrating write processing to a low resistance according to the third embodiment.

In examples of FIGS. 19 and 20, in order to switch between the three types of fixed resistors R1, R2a, and R2b, two bits are used as setting signals of the fixed resistors R1, R2a, and R2b. The setting of the fixed resistor R1 for executing a program to a high resistance is 0 x 0, and the settings of two load resistors for executing a program to a low resistance are 0 × 2 and 0 × 1.

Although the timing chart in FIG. 19 is basically the same as the timing chart in FIG. 5, the setting signal of the fixed resistor R1 is 0 × 0 in the example of FIG. 19. In the example of FIG. 19, as in FIG. 5, the bit line BL is turned on while the word line WL is kept on. This causes the voltage V to be applied only to the memory cell 10 at the corresponding address and the fixed resistor R1.

Although the timing chart in FIG. 20 is basically the same as the timing chart in FIG. 6, the setting signal of the fixed resistor R2a is 0 × 2 and the setting signal of the fixed resistor R2b is 0 × 1 in the example of FIG. 20. In the example of FIG. 20, the load resistor is switched from the fixed resistor R2a to the fixed resistor R2b while the word line WL is kept on. This causes the voltage V to be applied only to the memory cell 10 at the corresponding address and the fixed resistor R2a, and causes the voltage V to be applied only to the memory cell 10 at the corresponding address and the fixed resistor R2b in the middle of the pulse.

The write error rate from the high resistance state to the low resistance state can be lowered by changing the load resistor in the middle of the pulse of the voltage V as described above.

### <4. Fourth Embodiment>

### <4-1. Processing Example of Write Processing>

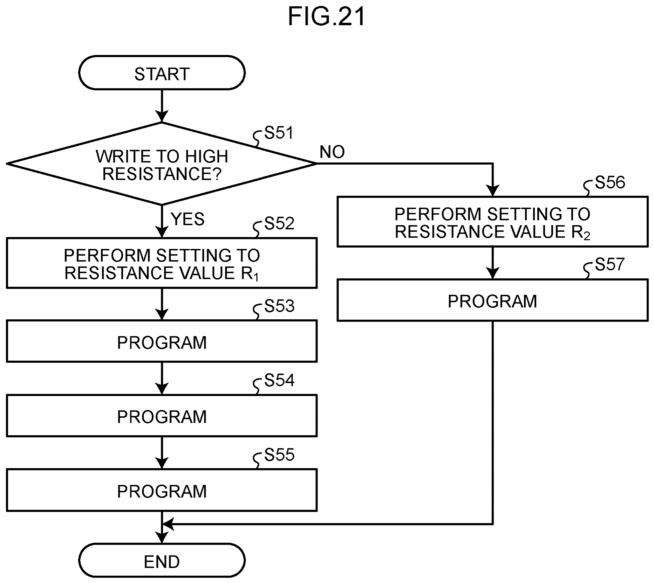

A processing example of write processing according to a fourth embodiment will be described with reference to FIG. 21. FIG. 21 is a flowchart illustrating the write processing according to the fourth embodiment. The fourth embodiment is basically the same as the first embodiment. The difference (write processing) therebetween will be described here.

In the fourth embodiment, the second embodiment is applied when a program (write) to a high resistance is executed. The third embodiment is applied when a program to a low resistance is executed. As a result, effects similar to those of the second and third embodiments can be obtained.

As illustrated in FIG. 21, in Step S51, whether or not write to a high resistance is performed, that is, whether or not the write data is 1 is determined. When it is determined that the write data is 1 (Yes in Step S51), a load resistor is set to the fixed resistor R1, that is, the resistance value of the load resistor is set to the resistance value R₁ of the fixed resistor R1 in Step S52.

In Step S53, a program is executed by using the set resistance value R₁. In Step S54, the program is similarly executed. In Step S55, the program is similarly executed. The program is repeatedly executed three times as described above, and data is written to the target magnetoresistive element 11. The write processing then ends.

Note that, in the above-described program executed three times, the write circuit 24 applies the predetermined voltage V to the magnetoresistive element 11 three times via the fixed resistor R1 of the load resistance circuit 241. This sets the resistance value R of the magnetoresistive element 11 to the high resistance value R_{H}.

In contrast, when it is not determined in Step S51 that the write data is 1 (No in Step S51), the load resistor is set to the fixed resistor R2, that is, the resistance value of the load resistor is set to the resistance value R₂ of the fixed resistor R2 in Step S56.

In Step S57, the set resistance value R₂ is used, and a program is executed. Data is written to the target magnetoresistive element 11. The write processing then ends.

Note that, in the above-described program, the write circuit 24 applies the predetermined voltage V to the magnetoresistive element 11 via the fixed resistor R2 of the load resistance circuit 241. This sets the resistance value R of the magnetoresistive element 11 to the low resistance value R_{L}.

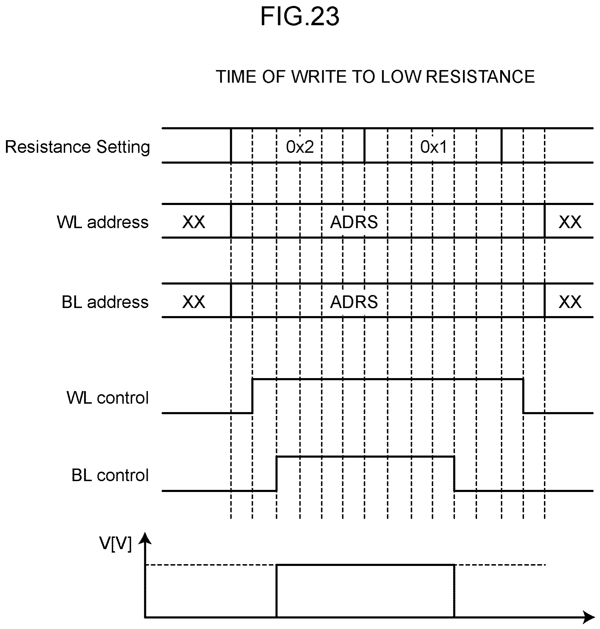

In such write processing, when a program to a high resistance is executed, the program is executed a plurality of number of times. When a program to a low resistance is executed, the program is executed once. Note, however, that, when the program to a low resistance is executed, one program (pulse width of pulse voltage) may be long as illustrated in the next timing chart (see FIG. 23).

### <4-2. Example of Timing Chart of Write Processing>

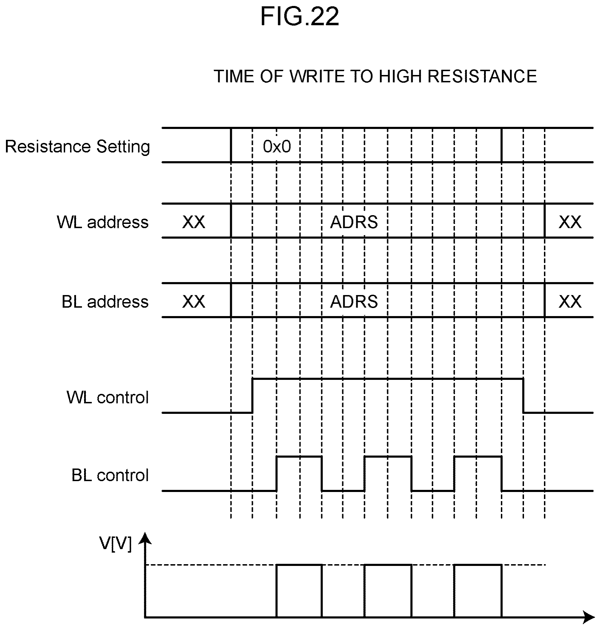

An example of a timing chart of write processing according to the fourth embodiment will be described with reference to FIGS. 22 and 23. FIG. 22 is a timing chart illustrating write processing to a high resistance according to the fourth embodiment. FIG. 23 is a timing chart illustrating write processing to a low resistance according to the fourth embodiment.

The timing chart in FIG. 22 is basically the same as the timing chart in FIG. 14. In an example of FIG. 22, the setting signal of the fixed resistor R1 is 0 × 0. In the example of FIG. 22, as in FIG. 14, the bit line BL is turned on three times while the word line WL is kept on. This causes the voltage V to be applied three times only to the memory cell 10 at the corresponding address and the fixed resistor R1. That is, the program is executed three times. This can lower the write error rate.

Although the timing chart in FIG. 23 is basically the same as the timing chart in FIG. 20, one pulse width is longer than that in the third embodiment in an example of FIG. 23. When a program for setting the state of the magnetoresistive element 11 from the high resistance state to the low resistance state is executed, as illustrated in FIG. 23, a load resistor is switched from the fixed resistor R2a to the fixed resistor R2b while the bit line BL is kept on. Note that, although one pulse width is longer than that in the third embodiment, this is not a limitation. One pulse width may be shorter than that in the third embodiment.

### <5. Fifth Embodiment>

### <5-1. Configuration Example of Storage Device>

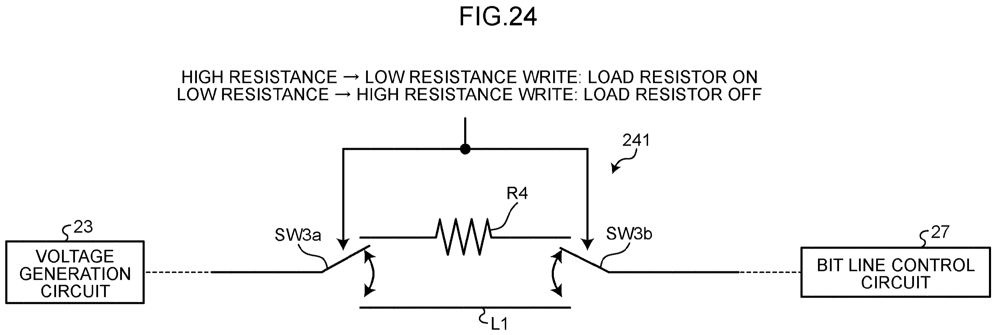

A configuration example of a storage device 100 according to a fifth embodiment will be described with reference to FIG. 24. FIG. 24 illustrates the configuration example of a load resistance circuit 241 of the storage device 100 according to the fifth embodiment. The storage device 100 according to the fifth embodiment is basically the same as that of the first embodiment. The difference (load resistance circuit 241) therebetween will be described here.

As illustrated in FIG. 24, the load resistance circuit 241 according to the fifth embodiment includes a fixed resistor R4, wiring L1, and a plurality of switches SW3a and SW3b. Each of the switches SW3a and SW3b receives a switching signal from a control circuit 22, and switches between paths. For example, each of the switches SW3a and SW3b switches between a wiring path passing through the fixed resistor R4 and a wiring path not passing through the fixed resistor R4. The wiring path not passing through the fixed resistor R4 passes through the wiring L1. Note that, although, in an example of FIG. 24, two switches SW3a and SW3b are provided, the number of switches SW3a and SW3b is not limited. For example, as in FIG. 3, only one switch may be provided.

The load resistance circuit 241 as described above switches between the switches SW3a and SW3b under the control of the control circuit 22, and switches between on/off of the fixed resistor R4. For example, the load resistance circuit 241 switches between the switches SW3a and SW3b. The load resistance circuit 241 turns on the fixed resistor R4 at the time of write from the high resistance to the low resistance, and turns off the fixed resistor R4 at the time of write from the low resistance to the high resistance. "On" is a state in which the fixed resistor R4 is connected to the voltage generation circuit 23 and the bit line control circuit 27. "Off" is a state in which the fixed resistor R4 is not connected to the voltage generation circuit 23 and the bit line control circuit 27. Note that other configurations are similar to those in the above-described first embodiment.

### <5-2. Processing Example of Write Processing>

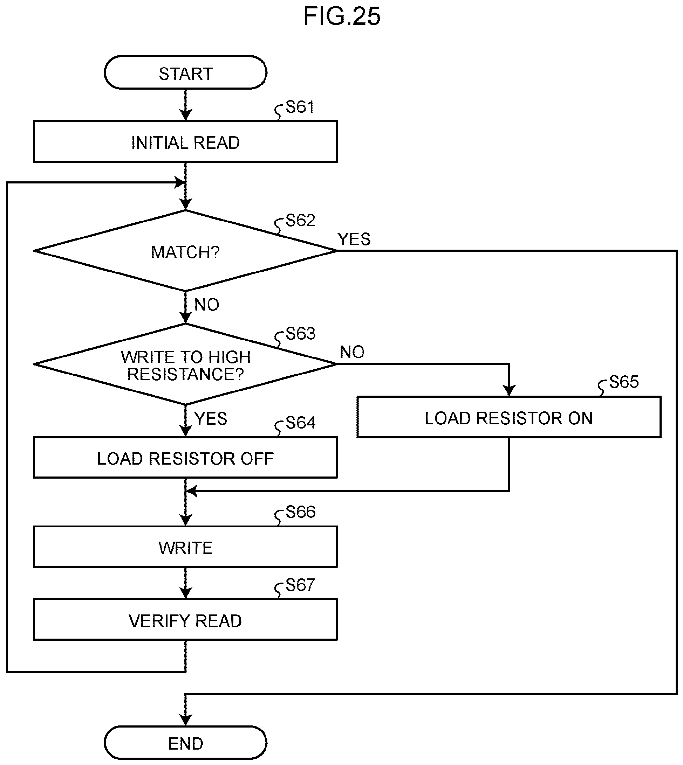

A processing example of write processing according to the fifth embodiment will be described with reference to FIG. 25. FIG. 25 is a flowchart illustrating the write processing according to the fifth embodiment.

The control circuit 22 (e.g., state machine of control circuit 22) controls the write processing. The flowchart is started by a write command input from an I/O 21 to the control circuit 22 and input of write data. Note that, for convenience, data corresponding to a low resistance state is 0, and data corresponding to a high resistance state is 1.

As illustrated in FIG. 25, in Step S61, initial read is executed. That is, whether read data is 1 or 0 is determined. In Step S62, whether or not the read data matches the write data is determined. When it is determined that the read data matches the write data (Yes in Step S62), the processing ends.

In contrast, when it is not determined in Step S62 that the read data matches the write data (No in Step S62), whether or not write to a high resistance is performed, that is, whether or not the write data is 1 is determined in Step S63.

When it is determined in Step S63 that the write data is 1 (Yes in Step S63), the fixed resistor R4 is set to off (load resistor off) in Step S64. The load resistance circuit 241 switches between the switches SW3a and SW3b under the switching control of the control circuit 22, and selects a wiring path not passing through the fixed resistor R4, that is, a wiring path passing through the wiring L1.

In contrast, when it is not determined in Step S63 that the write data is 1 (No in Step S63), the fixed resistor R4 is set to on (load resistor on) in Step S65. The load resistance circuit 241 switches between the switches SW3a and SW3b under the switching control of the control circuit 22, and selects a wiring path passing through the fixed resistor R4.

In Step S66, write (program) is executed based on the fixed resistor R4 set to on or off. In Step S67, verify read is executed. The processing returns to Step S62.

Note that, in the above-described write, the write circuit 24 applies the predetermined voltage V to the magnetoresistive element 11 without the fixed resistor R4 of the load resistance circuit 241. This sets the resistance value R of the magnetoresistive element 11 to the high resistance value R_{H}. Alternatively, the write circuit 24 applies the predetermined voltage V to the magnetoresistive element 11 via the fixed resistor R4 of the load resistance circuit 241. This sets the resistance value R of the magnetoresistive element 11 to the low resistance value R_{L}.

A voltage has been pulsed so that a constant voltage Vc having perpendicular magnetic anisotropy of 0 is applied only during a reversing period (time required for half rotation) of magnetization of the recording layer 113. Since, however, the reversing period of magnetization of the recording layer 113 depends on the strength of a magnetic field in the horizontal direction, and is a short period of, for example, 0.7 ns, pulse control with high accuracy of approximately 10.1 ns is required. Such pulse control is not easy, and the control becomes more difficult if element variation is considered.

In contrast, according to the fifth embodiment, write from a high resistance to a low resistance is facilitated. The fixed resistor R4 functioning as a load resistor causes a change to a resistance and a decrease in voltage distributed to the magnetoresistive element 11, which increases the perpendicular magnetic anisotropy. Precession centered on the horizontal magnetic field stops in a low resistance state. That is, in a VC-MRAM requiring short pulse control, a write method with a reversing probability that is not deteriorated despite a long pulse width can be achieved. Not only the highly accurate pulse width control can be made unnecessary and circuit design can be facilitated but deterioration of reversing probability due to variations of a pulse width and an element can be inhibited.

### <5-3. Example of Timing Chart of Write Processing>

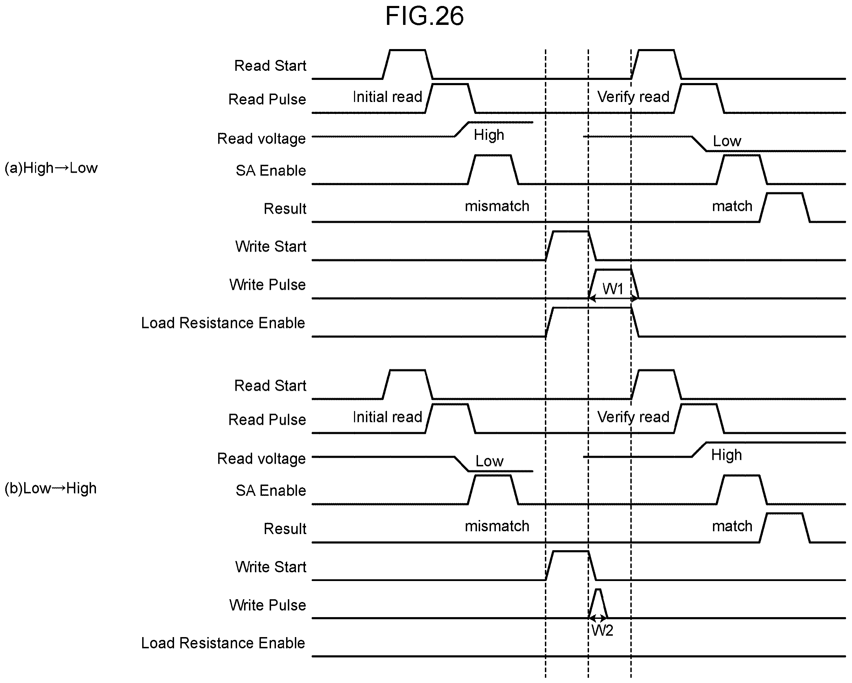

An example of a timing chart of write processing according to the fifth embodiment will be described with reference to FIG. 26. FIG. 26 is a timing chart illustrating write processing according to the fifth embodiment.

In (a) of FIG. 26, data of the memory cell 10 is rewritten from "High" to "Low". In (b) of FIG. 26, the data of the memory cell 10 is rewritten from "Low" to "High". Note that data corresponding to the low resistance value R_{L} is also referred to as "Low", and data corresponding to the high resistance value R_{H} is also referred to as "High". For example, the data "Low" corresponds to "0", and the data "High" corresponds to "1".

As illustrated in (a) and (b) of FIG. 26, initial read (Initial read) is performed. The control circuit 22 transmits a read start signal (Read Start) to the read circuit 25. The read circuit 25 issues a read pulse (Read Pulse). The read pulse is supplied to the bit line BL to which the memory cell 10 of a data write target is connected via the bit line control circuit 27.

A read voltage (Read voltage) from the magnetoresistive element 11 to be accessed is input to the sense amplifier 30. The control circuit 22 enables the sense amplifier 30 (SA Enable). Potential changes in accordance with the state of the resistance value R of the magnetoresistive element 11 (recording state of memory cell 10). The sense amplifier 30 thus detects a read voltage (High or Low) at the time when the potential is determined. The detection corresponds to detection of the resistance value R (high resistance value R_{H} or low resistance value R_{L}) of the magnetoresistive element 11. Therefore, the data of the memory cell 10 is read.

The control circuit 22 compares the data of the memory cell 10 read by the sense amplifier 30 with write data (data to be written). Here, the comparison result indicates mismatch (Result, mismatch). The control circuit 22 transmits a write start signal (Write Start) to the write circuit 24.

The write circuit 24 issues a write pulse (Write Pulse). The write pulse is supplied to the bit line BL to which the memory cell 10 of a data write target is connected via the bit line control circuit 27.

In (a) of FIG. 26, the write circuit 24 enables a load resistance function of the load resistance circuit 241 (Load Resistance Enable). The write circuit 24 applies a predetermined voltage (pulse width W1) to the magnetoresistive element 11 via the fixed resistor R4 of the load resistance circuit 241. This causes the resistance value R of the magnetoresistive element 11 to be switched from the high resistance value R_{H} to the low resistance value R_{L}, and causes the data "High" to be written.

In (b) of FIG. 26, the write circuit 24 does not enable the load resistance function of load resistance circuit 241. The write circuit 24 applies a predetermined voltage V (pulse width W2) to the magnetoresistive element 11. This causes the resistance value R of the magnetoresistive element 11 to be switched from the low resistance value R_{L} to the high resistance value R_{H}, and causes the data "Low" to be written.

In examples of (a) and (b) of FIG. 26, the voltage V having a different pulse width (voltage V of pulse width W1 or W2) is applied to the magnetoresistive element 11 in accordance with on/off of the fixed resistor R4.

Thereafter, verify read (Verify read) is performed. The control circuit 22 compares the data of the memory cell 10 read by the verify read with write data (data to be written). Here, the comparison result indicates match (Result, match). Therefore, the data write ends.

### <5-4. Example of Characteristics of Magnetoresistive Element>

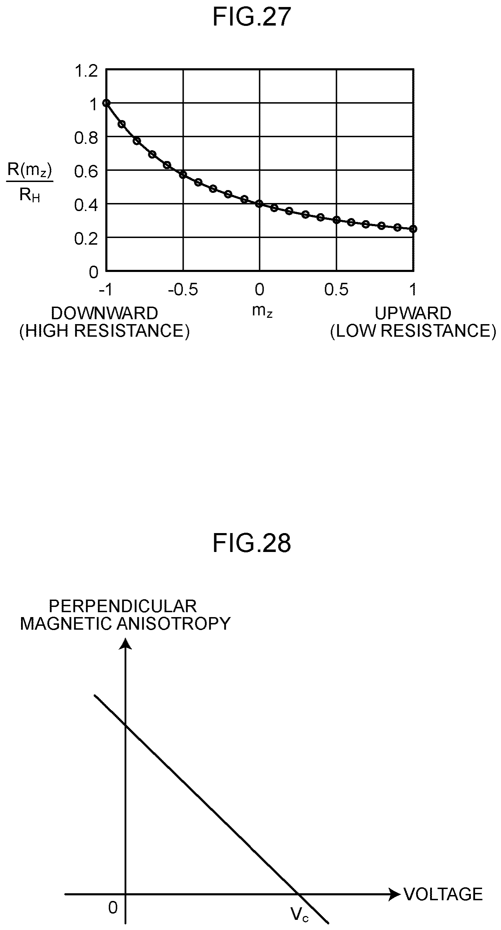

An example of the characteristics of the magnetoresistive element 11 according to the fifth embodiment will be described with reference to FIG. 27. FIG. 27 is a graph illustrating the characteristics of the magnetoresistive element 11 according to the fifth embodiment.

FIG. 27 illustrates the relation between the magnetization component m_{Z} of the recording layer 113 and the resistance ratio R(m_{Z})/R_{H} of the magnetoresistive element 11. The horizontal axis of the graph indicates the magnetization component m_{Z} of the recording layer 113. The magnetization component m_{Z} is the magnitude of magnetization of the recording layer 113 in the Z-axis direction. When the magnetization component m_{Z} is 1, the magnetization direction of the recording layer 113 is in the Z-axis positive direction (upward direction). When the magnetization component m_{Z} is -1, the magnetization direction of the recording layer 113 is in the Z-axis negative direction (downward direction). The vertical axis of the graph indicates the resistance ratio R(m_{Z})/R_{H} of the magnetoresistive element 11 normalized by a high resistance value R_{High}. R(m_{Z}) is a resistance value of the magnetoresistive element 11 that changes in accordance with the magnetization component m_{Z}.

When the magnetization of the recording layer 113 rotates, the magnetization component m_{Z} changes between -1 and 1. When the magnetization component m_{Z} is 1, the magnetization direction of the recording layer 113 is in the Z-axis positive direction in the same manner as that of the magnetization direction of the fixed layer 111, and the resistance value R of the magnetoresistive element 11 is the low resistance value R_{L}. In contrast, when the magnetization component m_{Z} is -1, the magnetization direction of the recording layer 113 is in the Z-axis negative direction in a manner opposite to that of the magnetization direction of the fixed layer 111, and the resistance value R of the magnetoresistive element 11 is the high resistance value R_{H}. The resistance value R of the magnetoresistive element 11 gradually changes between the low resistance value R_{L} and the high resistance value R_{H} during rotation of the magnetization of the recording layer 113.

### <5-5. Example of Voltage Dependency of Perpendicular Magnetic Anisotropy of Magnetoresistive Element>

An example of the voltage dependency of the perpendicular magnetic anisotropy of the magnetoresistive element 11 according to the fifth embodiment will be described with reference to FIG. 28. FIG. 28 is a graph illustrating the voltage dependency of the perpendicular magnetic anisotropy (constant) of the magnetoresistive element 11 according to the fifth embodiment. The horizontal axis of the graph indicates the voltage V. The vertical axis of the graph indicates the perpendicular magnetic anisotropy of the recording layer 113.

As illustrated in FIG. 28, larger perpendicular magnetic anisotropy makes the recording layer 113 more likely to be magnetized in the perpendicular direction. More specifically, positive perpendicular magnetic anisotropy makes the recording layer 113 more likely to be magnetized in the perpendicular direction (Z-axis direction). Negative perpendicular magnetic anisotropy makes the recording layer 113 more likely to be magnetized in the horizontal direction (XY plane direction).

As understood from the graph, when the voltage V is 0, that is, when no voltage V is applied to the magnetoresistive element 11, the perpendicular magnetic anisotropy is positive. The recording layer 113 in the case is more likely to be magnetized in the perpendicular direction. When the voltage V is applied to the magnetoresistive element 11, the value of the perpendicular magnetic anisotropy changes. Specifically, as the voltage V increases, the perpendicular magnetic anisotropy decreases. When the voltage V exceeds a certain voltage Vc, the perpendicular magnetic anisotropy becomes negative. The recording layer 113 in the case is more likely to be magnetized in the horizontal direction.

When the voltage V, which makes the recording layer 113 more likely to be magnetized in the horizontal direction as described above, is applied to the magnetoresistive element 11, the magnetization of the recording layer 113 of the magnetoresistive element 11 is rotated by precession centered on the horizontal magnetic field. The magnetization of the recording layer 113 is reversed by using the rotation to switch the resistance value R of the magnetoresistive element 11 between the low resistance value R_{L} and the high resistance value R_{H}. Data can be thereby written to the memory cell 10.

### <5-6. Example of Voltage Division Through Load Resistor>

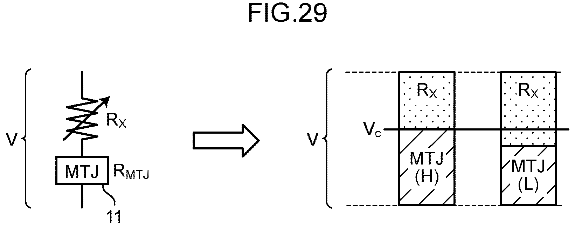

An example of voltage division through the fixed resistor R4 according to the fifth embodiment will be described with reference to FIG. 29. FIG. 29 illustrates voltage division in a case where the voltage V is applied to the magnetoresistive element 11 via the fixed resistor R4 according to the fifth embodiment. In an example of FIG. 29, a load resistor R_{X} corresponds to the fixed resistor R4.

As illustrated in FIG. 29, when the magnetoresistive element 11 is in the high resistance state and the voltage V is applied to the load resistor R_{X} and the magnetoresistive element 11, the voltage Vc is applied to the magnetoresistive element 11 by voltage division. When the magnetoresistive element 11 is in the low resistance state and the same voltage V is applied to the load resistor R_{X} and the magnetoresistive element 11, a voltage distributed to the load resistor R_{X} is large, and the voltage of the magnetoresistive element 11 is smaller than the voltage Vc. In the voltage Vc, reversing making the perpendicular magnetic anisotropy 0 occurs. The voltage Vc is applied to the magnetoresistive element 11 in the high resistance state, and reversing occurs while no reversing occurs in the magnetoresistive element 11 in the low resistance state. Furthermore, when the magnetoresistive element 11 changes from the high resistance state to the low resistance state, the distributed voltage decreases. The perpendicular magnetic anisotropy thus increases, and reversing operation stops.

### <5-7. Example of Voltage Change of Magnetoresistive Element>

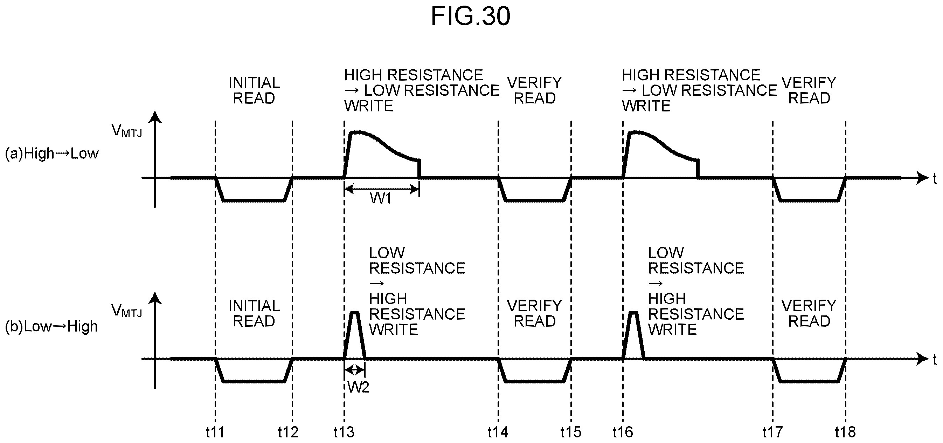

An example of a voltage change of the magnetoresistive element 11 according to the fifth embodiment will be described with reference to FIG. 30. FIG. 30 illustrates the voltage change of the magnetoresistive element 11 according to the fifth embodiment.

In an example of FIG. 30, changes in a voltage V_{MTJ} in a case (a) of write from a high resistance to a low resistance and a case (b) of write from a low resistance to a high resistance are illustrated with the voltage of the magnetoresistive element 11 as V_{MTJ}. In (a) of FIG. 30, initial read data is "High", and write data is "Low". In (b) of FIG. 30, initial read data is "Low", and write data is "High".

From time t11 to time t12, initial read of data is performed. The read circuit 25 detects the resistance value R of the magnetoresistive element 11 by applying a low voltage that does not reverse the magnetization of the recording layer 113 to the magnetoresistive element 11. In (a) of FIG. 30, the high resistance value R_{H} is detected. In (b) of FIG. 30, the low resistance value R_{L} is detected.

At time t13, data is written. The write circuit 24 reverses the magnetization of the recording layer 113 so that the resistance value R of the magnetoresistive element 11 is switched between the low resistance value R_{L} and the high resistance value R_{H}.

In (a) of FIG. 30, the write circuit 24 applies the predetermined voltage V (pulse width W1) to the magnetoresistive element 11, in which the resistance value R has been detected to be the high resistance value R_{H} by the read circuit 25, via the fixed resistor R4 of the load resistance circuit 241. This causes the resistance value R of the magnetoresistive element 11 to be switched from the high resistance value R_{H} to the low resistance value R_{L}, and causes the data "Low" to be written.

In (b) of FIG. 30, the write circuit 24 applies the predetermined voltage V (pulse width W2) to the magnetoresistive element 11, in which the resistance value R has been detected to be the low resistance value R_{L} by the read circuit 25, without the fixed resistor R4 of the load resistance circuit 241. This causes the resistance value R of the magnetoresistive element 11 to be switched from the low resistance value R_{L} to the high resistance value R_{H}, and causes the data "High" to be written. Note that the pulse width W2 of the voltage V may be the same as that within the reversing period of the magnetization of the recording layer 113, for example.

From time t14 to time t15, verify read is performed. In order to determine whether or not the write circuit 24 has switched the resistance value R of the magnetoresistive element 11, the read circuit 25 detects the resistance value R of the magnetoresistive element 11 by applying a voltage that does not reverse the magnetization of the recording layer 113 to the magnetoresistive element 11.

The recording state of the memory cell 10, that is, whether or not the resistance value R of the magnetoresistive element 11 has been correctly switched is checked. Here, it is assumed that data write failed at the above-described time t13 and the same resistance value R as that at the initial read is detected. Therefore, data is written again.

At time t16, data is written. Details are similar to those of the data write at the above-described time t13, and thus the description thereof will not be repeated.

From time t17 to time t18, verify read is performed. Here, it is assumed that data write has succeeded at the above-described time t16. Therefore, the data write ends.

As illustrated in (a) of FIG. 30, in a case of write from a high resistance to a low resistance, a voltage distributed to the magnetoresistive element 11 changes in accordance with a resistance change through the fixed resistor R4. A voltage decreases with a resistance change to increase the perpendicular magnetic anisotropy, which stops the precession centered on the horizontal magnetic field. A low resistance state thus stops a change of a magnetization vector, and no oscillation of the reversing probability occurs.

In contrast, as illustrated in (b) of FIG. 30, in a case of write from a low resistance to a high resistance, there are no voltage change and no change in the perpendicular magnetic anisotropy since the fixed resistor R4 is not used, and the precession centered on the horizontal magnetic field continues. Continued precession oscillates the reversing probability, so that appropriately turning off the voltage is required.

### <5-8. Example of Simulation Result of Write>

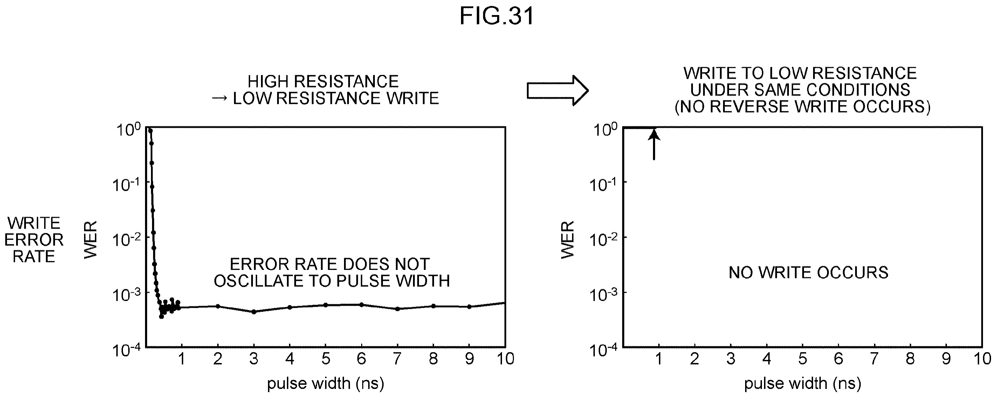

An example of a simulation result of write according to the fifth embodiment will be described with reference to FIG. 31. FIG. 31 illustrates a simulation result in a case where a pulse voltage is applied to the magnetoresistive element 11 in a high resistance state or a low resistance state according to the fifth embodiment via the fixed resistor R4.

As in a left graph of FIG. 31, when the pulse voltage is applied to the magnetoresistive element 11 in the high resistance state via the fixed resistor R4, the write error rate does not oscillate to the pulse width. That is, write that does not oscillate to the pulse width of the pulse voltage can be achieved by applying the pulse voltage via the fixed resistor R4. Furthermore, as in a right graph of FIG. 31, when the pulse voltage is applied to the magnetoresistive element 11 in the low resistance state via the fixed resistor R4 on the same conditions as the left graph of FIG. 31, no write occurs. That is, no reverse write occurs.

As described above, write from a high resistance to a low resistance is facilitated. A load resistor causes a change to a resistance and a decrease in voltage distributed to the magnetoresistive element 11, which increases the magnetic anisotropy. Precession centered on the horizontal magnetic field stops in a low resistance state. Note that write from a low resistance to a high resistance is similar to conventional write.

### <5-9. Variation 1 of Write Processing>

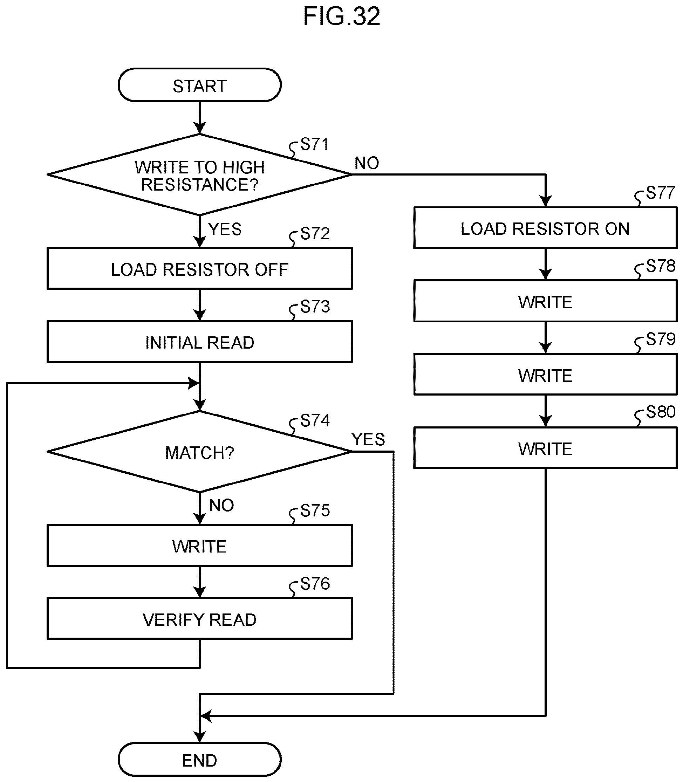

Variation 1 of the write processing according to the fifth embodiment will be described with reference to FIG. 32. FIG. 32 is a flowchart illustrating the write processing according to Variation 1 of the fifth embodiment. Variation 1 is basically the same as the fifth embodiment. The difference (write processing) therebetween will be described here.

As illustrated in FIG. 32, in Step S71, whether or not write to a high resistance is performed, that is, whether or not the write data is 1 is determined. When it is determined that the write data is 1 (Yes in Step S71), the fixed resistor R4 is set to off (load resistor off) in Step S72. The load resistance circuit 241 switches between the switches SW3a and SW3b under the switching control of the control circuit 22, and selects a wiring path not passing through the fixed resistor R4.

In Step S73, initial read is executed. That is, whether read data is 1 or 0 is determined. In Step S74, whether or not the read data matches the write data is determined. When it is determined that the read data matches the write data (Yes in Step S74), the processing ends.

In contrast, when it is not determined in Step S74 that the read data matches the write data (No in Step S74), write (program) is executed based on the fixed resistor R4 set to off in Step S75. In Step S76, verify read is executed. Thereafter, the processing returns to Step S74.

Note that, in the above-described write, the write circuit 24 applies the predetermined voltage V to the magnetoresistive element 11 without the fixed resistor R4 of the load resistance circuit 241. This sets the resistance value R of the magnetoresistive element 11 to the high resistance value R_{H}.

When it is not determined in Step S71 that the write data is 1 (No in Step S63), the fixed resistor R4 is set to on (load resistor on) in Step S77. The load resistance circuit 241 switches between the switches SW3a and SW3b under the switching control of the control circuit 22, and selects a wiring path passing through the fixed resistor R4.

In Step S78, write (program) is executed by using the fixed resistor R4 set to on. In Step S79, write is similarly executed. In Step S80, write is similarly executed. The write is repeatedly executed three times as described above, and data is written to the target magnetoresistive element 11. The write processing then ends.

Note that, in the above-described write executed three times, the write circuit 24 applies the predetermined voltage V to the magnetoresistive element 11 three times via the fixed resistor R4 of the load resistance circuit 241. This sets the resistance value R of the magnetoresistive element 11 to the low resistance value R_{L}.

Furthermore, write from a high resistance to a low resistance via the fixed resistor R4 does not depend on the pulse width, and no reverse write occurs, so that the initial read can be omitted. Moreover, in order to improve the write error rate, voltages having the same pulse width or different pulse widths can be applied.

### <6. Sixth Embodiment>

### <6-1. Processing Example of Write Processing>

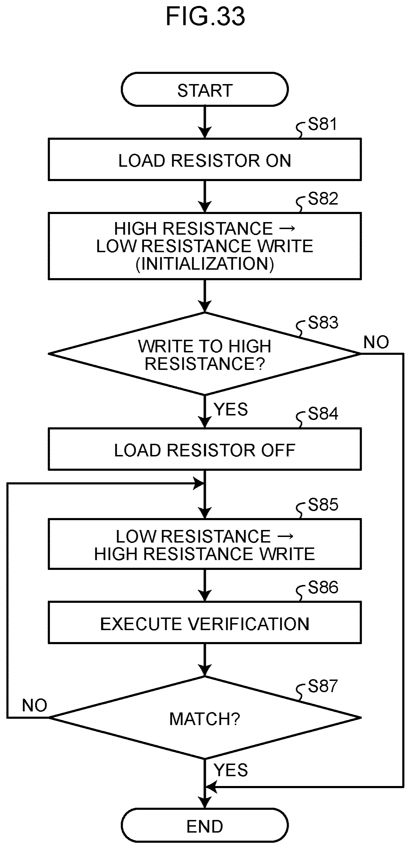

A processing example of write processing according to a sixth embodiment will be described with reference to FIG. 33. FIG. 33 is a flowchart illustrating the write processing according to the sixth embodiment. The sixth embodiment is basically the same as the fifth embodiment. The difference (write processing) therebetween will be described here.

In the sixth embodiment, data write to the memory cell 10 includes initialization instead of including the initial read. The initialization makes the initial read unnecessary. For example, the write circuit 24 uses write from a high resistance to a low resistance using the fixed resistor R4 for the initialization.

In the magnetoresistive element 11 in the low resistance state, a voltage distributed to the fixed resistor R4 is increased to decrease the voltage V_{MTJ}. In this case, the perpendicular magnetic anisotropy does not decrease, and no precession centered on the horizontal magnetic field occurs, so that no reversing occurs. Therefore, since reversing occurs only in the magnetoresistive element 11 in the high resistance state, the magnetoresistive element 11 can be adjusted to the low resistance state without depending on the initial state. Initialization is made possible, which makes the initial read unnecessary.

As illustrated in FIG. 33, in Step S81, the fixed resistor R4 is set to on (load resistor on). In Step S82, write (initialization) from a high resistance to a low resistance is executed.

Note that, in the above-described write, the write circuit 24 applies the predetermined voltage V to the magnetoresistive element 11 via the fixed resistor R4 of the load resistance circuit 241. This initializes the resistance value R of the magnetoresistive element 11 to the low resistance value R_{L}.

In Step S83, whether or not write to a high resistance is performed, that is, whether or not the write data is 1 is determined. When it is not determined that the write data is 1 (No in Step S83), the processing ends.

In contrast, when it is determined that the write data is 1 (Yes in Step S83), the fixed resistor R4 is set to off (load resistor off) in Step S84. In Step S85, write from a low resistance to a high resistance is executed based on the fixed resistor R4 set to off.

Note that, in the above-described write, the write circuit 24 applies the constant voltage V to the magnetoresistive element 11. The resistance value R of the magnetoresistive element 11 is switched from the low resistance value R_{L} to the high resistance value R_{H}.

In Step S86, verification (verify read) is executed. In Step S87, whether or not the read data matches the write data is determined. When it is determined that the read data matches the write data (Yes in Step S87), the processing ends. In contrast, when it is not determined that the read data matches the write data (No in Step S87), the processing returns to Step S85.

In such processing, the fixed resistor R4 is turned on, and initialization is performed. Thereafter, a voltage is applied to all the magnetoresistive elements 11 (all bits) at a designated address. Since no voltage is applied to the magnetoresistive element 11 in the low resistance state, the perpendicular magnetic anisotropy increases, and no reversing occurs. Since a voltage is applied to the magnetoresistive element 11 in the high resistance state, the perpendicular magnetic anisotropy decreases, and reversing occurs. Only the magnetoresistive elements 11 in the high resistance state change to the low resistance state, and all the magnetoresistive elements 11 at a target address can be set to the low resistance state.

The fixed resistor R4 is turned off and write is performed only for the magnetoresistive element 11 in which the write data is 1 and write to the high resistance state is necessary. Verification is performed for checking a result. The recording state is read, and whether or not the magnetoresistive element 11 is in the high resistance state is determined. When the magnetoresistive element 11 is in the high resistance state, the processing ends. When the magnetoresistive element 11 is not in the high resistance state, the write processing is performed again. Note that the maximum number of times of verifications and rewrites may be provided, for example.

### <6-2. Example of Timing Chart of Write Processing>

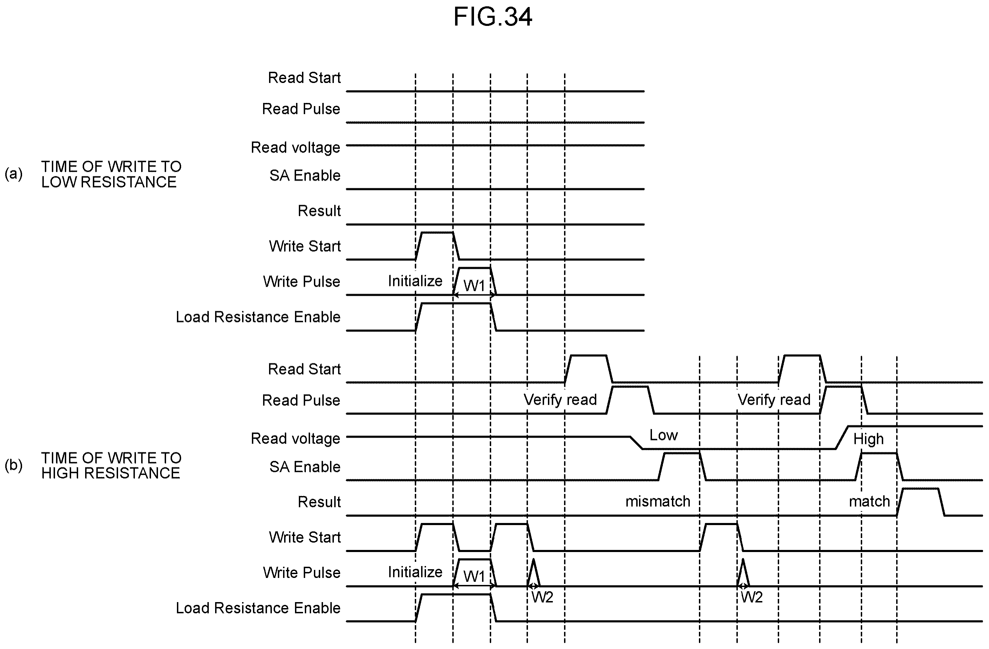

An example of a timing chart of write processing according to the sixth embodiment will be described with reference to FIG. 34. FIG. 34 is a timing chart illustrating the write processing according to the sixth embodiment.

In the sixth embodiment, the resistance state of the magnetoresistive element 11 is adjusted to the low resistance state by initialization. In the initialization, a voltage is applied to the magnetoresistive elements 11 in both the low resistance state and the high resistance state via the fixed resistor R4. The magnetoresistive element 11 in the low resistance state does not change, and write to the low resistance state is performed in the magnetoresistive element 11 in the high resistance state. A pulse of a constant voltage is applied to the magnetoresistive element 11 (bit) in which write data is 1 (high resistance state), and write is performed.

In (a) of FIG. 34, data "Low" is written at the time of write to a low resistance. In (b) of FIG. 34, data "High" is written at the time of write to a high resistance. In an example of FIG. 34, the magnetoresistive element 11 is initialized to the low resistance state. Write is performed only for the magnetoresistive element 11 in which write data is 1 (high resistance state).

As illustrated in (a) of FIG. 34, initialization (Initialize) is performed. The write circuit 24 issues a write pulse (Write Pulse). The write pulse is supplied to the bit line BL to which the memory cell 10 of a data write target is connected via the bit line control circuit 27. The write circuit 24 applies the predetermined voltage V (pulse width W1) to the magnetoresistive element 11 via the fixed resistor R4 of the load resistance circuit 241. This initializes the resistance value R of the magnetoresistive element 11 to the low resistance value R_{L}.

In (a) of FIG. 34, the data "Low" is written by the above-described initialization, and the data write ends. Note that verify read may be performed.

In (b) of FIG. 34, data "High" is written. The write circuit 24 issues a write pulse (Write Pulse). The write circuit 24 applies the predetermined voltage V (pulse width W2) to the magnetoresistive element 11 without the fixed resistor R4 of the load resistance circuit 241. This sets the resistance value R of the magnetoresistive element 11 to the high resistance value R_{H}.

Thereafter, verify read (Verify read) is performed. Here, the comparison result indicates mismatch (Result, mismatch). Therefore, data is written again. In the subsequent verify read, the comparison result indicates match (Result, match), the data write ends.

### <6-3. Example of Voltage Change of Magnetoresistive Element>

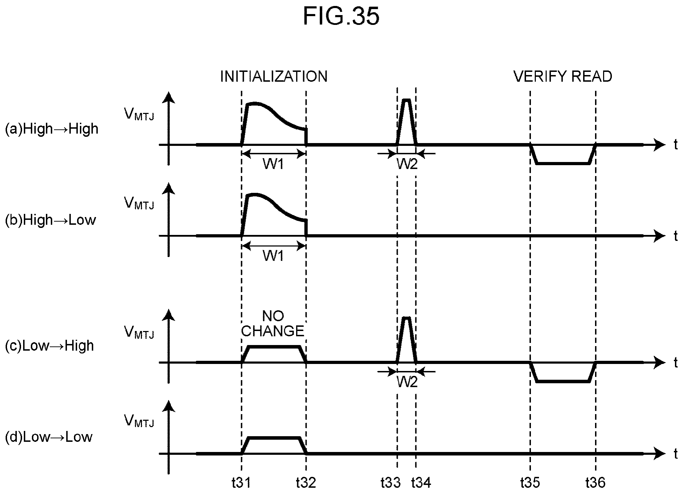

An example of a voltage change of the magnetoresistive element 11 according to the sixth embodiment will be described with reference to FIG. 35. FIG. 35 illustrates the voltage change of the magnetoresistive element 11 according to the sixth embodiment.

In the sixth embodiment, when the magnetoresistive element 11 is in the high resistance state, the magnetoresistive element 11 is initialized to the low resistance state, and write is performed only when the write data is 1 (high resistance state). When the magnetoresistive element 11 is in the low resistance state, the state does not change, and write is performed only when the write data is 1 (high resistance state).

In (a) of FIG. 35, data before initialization is "High", and the write data is also "High". In (b) of FIG. 35, the data before initialization is "High", and the write data is "Low". In (c) of FIG. 35, the data before initialization is "Low", and the write data is "High". In (d) of FIG. 35, the data before initialization is "Low", and the write data is also "Low". The write data is data to be written.

As illustrated in FIG. 35, initialization is performed from time t31 to time t32. The write circuit 24 applies a predetermined voltage (pulse width W1) to the magnetoresistive element 11 via the fixed resistor R4 of the load resistance circuit 241. This initializes the resistance value R of the magnetoresistive element 11 to the low resistance value R_{L}. In (a) and (b) of FIG. 35, the resistance value R of the magnetoresistive element 11 is switched from the high resistance value R_{H} to the low resistance value R_{L}. In (c) and (d) of FIG. 35, the resistance value R of the magnetoresistive element 11 remains to be the high resistance value R_{H} (no change).

From time t33 to time t34, data is written as necessary. In (a) and (c) of FIG. 35, the data "High" is written. The write circuit 24 applies the predetermined voltage (pulse width W2) to the magnetoresistive element 11. This causes the resistance value R of the magnetoresistive element 11 to be switched from the low resistance value R_{L} to the high resistance value R_{H}. In (b) and (d) of FIG. 35, no data is written.

From time t35 to time t36, verify read is performed as necessary. In (a) and (c) of FIG. 35, verify read is performed in accordance with the data write from the time t33 to the time t34 described above. Here, it is assumed that data write has succeeded. Therefore, the data write ends. In (b) and (d) of FIG. 35, verify read is omitted, and the data write ends. Note, however, that verify read may also be performed in (b) and (d) of FIG. 35.

### <7. Seventh Embodiment>

### <7-1. Processing Example of Write Processing>

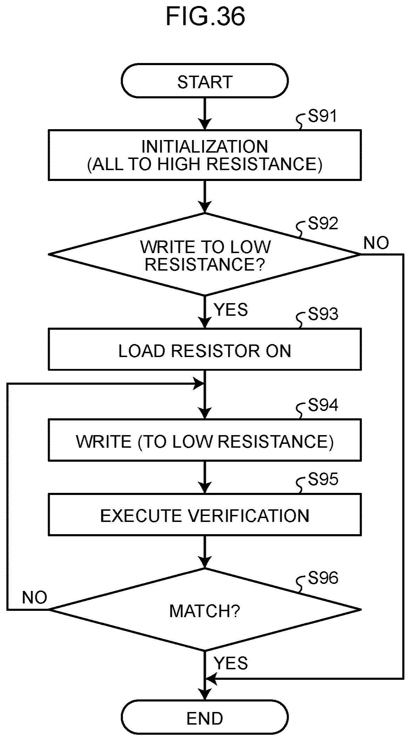

A processing example of write processing according to a seventh embodiment will be described with reference to FIG. 36. FIG. 36 is a flowchart illustrating the write processing according to the seventh embodiment. The seventh embodiment is basically the same as the fifth embodiment. The difference (write processing) therebetween will be described here.

In the seventh embodiment, the first embodiment is combined with Non Patent Literature. In the first embodiment, pulse control of write from a high resistance to a low resistance is facilitated by using a load resistor (e.g., fixed resistors R1 and R2). In Non Patent Literature, pulse control of write from a low resistance to a high resistance is facilitated by using a magnetic field in the perpendicular direction. In the seventh embodiment, a method in Non Patent Literature is used for initialization to facilitate pulse control in both directions by being combined with the first embodiment.

As described above, write from a high resistance to a low resistance is facilitated. Furthermore, the fixed resistor R4 causes a change to a resistance and a decrease in voltage distributed to the magnetoresistive element 11, which increases the perpendicular magnetic anisotropy. Precession centered on the horizontal magnetic field stops in a low resistance state. Furthermore, initialization (write from low resistance to high resistance) is also facilitated. Short pulse control is made unnecessary in both write from a low resistance to a high resistance and write from a high resistance to a low resistance in combination with the method of Non Patent Literature.

As illustrated in FIG. 36, in Step S91, initialization (all initialized to high resistance) is performed. The predetermined voltage V is applied to all the magnetoresistive elements 11 (all bits) at a designated address. This initializes the resistance value R of the magnetoresistive element 11 to the high resistance value R_{H}.

In Step S92, whether or not write to a low resistance is performed, that is, whether or not the write data is 0 is determined. When it is not determined that the write data is 0 (No in Step S92), the processing ends.

In contrast, when it is determined that the write data is 0 (Yes in Step S92), the fixed resistor R4 is set to on (load resistor on) in Step S93. This enables the load resistance function of the load resistance circuit 241. In Step S94, write from a high resistance to a low resistance is executed based on the fixed resistor R4 set to off.

Note that, in the above-described write, the write circuit 24 applies the predetermined voltage V to the magnetoresistive element 11 via the fixed resistor R4 of the load resistance circuit 241. This causes the resistance value R of the magnetoresistive element 11 to be switched from the high resistance value R_{H} to the low resistance value R_{L}.

In Step S95, verification (verify read) is executed. Thereafter, in Step S96, whether or not the read data matches the write data is determined. When it is determined that the read data matches the write data (Yes in Step S96), the processing ends. In contrast, when it is not determined that the read data matches the write data (No in Step S96), the processing returns to Step S94.

### <7-2. Example of Timing Chart of Write Processing>

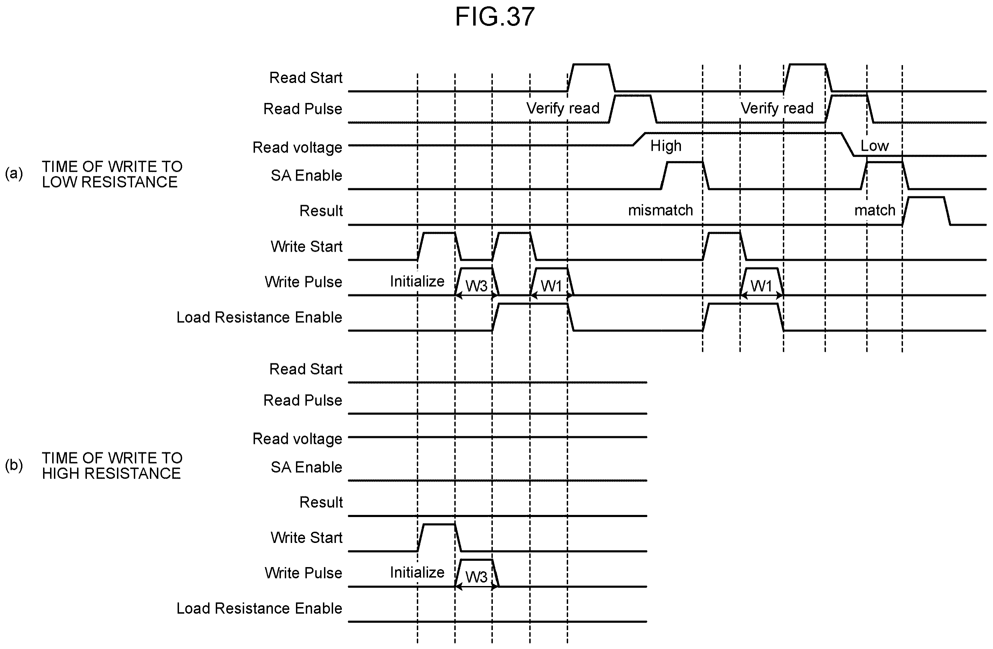

An example of a timing chart of write processing according to the seventh embodiment will be described with reference to FIG. 37. FIG. 37 is a timing chart illustrating the write processing according to the seventh embodiment.

In the seventh embodiment, the method in Non Patent Literature is used for initialization to adjust the magnetoresistive element 11 to a high resistance state. As in the second embodiment 2, write is performed to the magnetoresistive element 11 (bit) in which the write data is 0 (low resistance state) via the fixed resistor R4. In the write according to the seventh embodiment, precession is stopped by performing write using the fixed resistor R4, which makes conventional generation of a short pulse unnecessary and facilitates pulse control.

In (a) of FIG. 37, data "Low" is written at the time of write to a low resistance. In (b) of FIG. 37, data "High" is written at the time of write to a high resistance. In an example of FIG. 37, the magnetoresistive element 11 is initialized to the high resistance state. Write is performed only for the magnetoresistive element 11 in which write data is 0 (low resistance state). In addition, a write pulse is illustrated to be longer than that in FIG. 34.

As illustrated in (a) of FIG. 37, initialization (Initialize) is performed. The write circuit 24 issues a write pulse (Write Pulse). The write pulse is supplied to the bit line BL to which the memory cell 10 of a data write target is connected via the bit line control circuit 27. The write circuit 24 applies a predetermined voltage V (pulse width W3) to the magnetoresistive element 11. This initializes the resistance value R of the magnetoresistive element 11 to the high resistance value R_{H}.

In (a) of FIG. 37, data "Low" is written. The write circuit 24 issues a write pulse (Write Pulse). The write circuit 24 applies the predetermined voltage V (pulse width W1) to the magnetoresistive element 11 via the fixed resistor R4 of the load resistance circuit 241. This causes the resistance value R of the magnetoresistive element 11 to be switched from the high resistance value R_{H} to the low resistance value R_{L}.

Thereafter, verify read (Verify read) is performed. Here, the comparison result indicates mismatch (Result, mismatch). Therefore, data is written again. In the subsequent verify read, the comparison result indicates match (Result, match), the data write ends.

In (b) of FIG. 37, the data "High" is written by the above-described initialization, and the data write ends. Note that verify read may be performed.

### <7-3. Example of Voltage Change of Magnetoresistive Element>

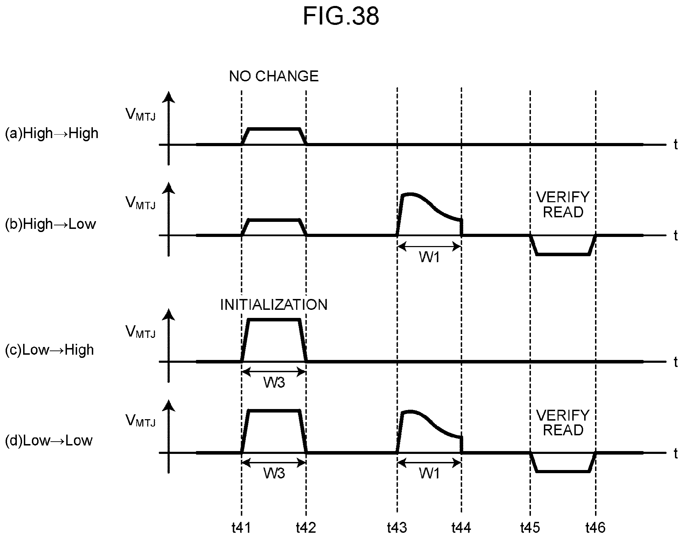

An example of a voltage change of the magnetoresistive element 11 according to the seventh embodiment will be described with reference to FIG. 38. FIG. 38 illustrates the voltage change of the magnetoresistive element 11 according to the seventh embodiment.

In (a) of FIG. 38, data before initialization is "High", and the write data is also "High". In (b) of FIG. 38, the data before initialization is "High", and the write data is "Low". In (c) of FIG. 38, the data before initialization is "Low", and the write data is "High". In FIG. 38(d), the data before initialization is "Low", and the write data is also "Low". The write data is data to be written.

Initialization is performed from time t41 to time t42. The write circuit 24 applies the predetermined voltage V (pulse width W3) of the magnetoresistive element 11. This initializes the resistance value R of the magnetoresistive element 11 to the high resistance value R_{H}. The pulse width W3 of the voltage V here may be longer than the pulse width W2 (see FIGS. 30 and 35). In (a) and (b) of FIG. 38, the resistance value R of the magnetoresistive element 11 remains to be the high resistance value R_{H} (no change). In (c) and (d) of FIG. 38, the resistance value R of the magnetoresistive element 11 is switched from the low resistance value R_{L} to the high resistance value R_{H}.

From time t43 to time t44, data is written as necessary. In (a) and (c) of FIG. 38, no data is written. In (b) and (d) of FIG. 38, data is written. The write circuit 24 applies the predetermined voltage V (pulse width W1) to the magnetoresistive element 11 via the fixed resistor R4 of the load resistance circuit 241. This causes the resistance value R of the magnetoresistive element 11 to be switched from the high resistance value R_{H} to the low resistance value R_{L}, and causes the data "Low" to be written.

From time t45 to time t46, verify read is performed as necessary. In (a) and (c) of FIG. 38, verify read is omitted, and the data write ends. Note, however, that verify read may be performed. In (b) and (d) of FIG. 38, verify read is performed in accordance with the data write from the time t43 to the time t44 described above. Here, it is assumed that data write has succeeded. Therefore, the data write ends.

In such processing, first, the method in Non Patent Literature is used to perform initialization to a high resistance state. A predetermined constant voltage is applied to all the magnetoresistive elements 11 (all bits) at a designated address. Next, write to a low resistance state is performed to the magnetoresistive element 11 (bit) in which the write data is 0. In the case, the fixed resistor R4 is set to on, and write is performed. Verification is performed for checking a result. The recording state is read, and whether or not the magnetoresistive element 11 is in the high resistance state is determined. When the magnetoresistive element 11 is in the high resistance state, the processing ends. When the magnetoresistive element 11 is not in the high resistance state, the write processing is performed again. Note that the maximum number of times of verifications and rewrites may be provided, for example.

In the seventh embodiment, when the magnetoresistive element 11 is in the high resistance state, the state does not change, and write is performed only when the write data is 0 (low resistance state). When the magnetoresistive element 11 is in the low resistance state, the magnetoresistive element 11 is initialized to the high resistance state, and write is performed only when the write data is 0 (low resistance state).

### <8. Eighth Embodiment>

### <8-1. Example of Timing Chart of Write Processing>

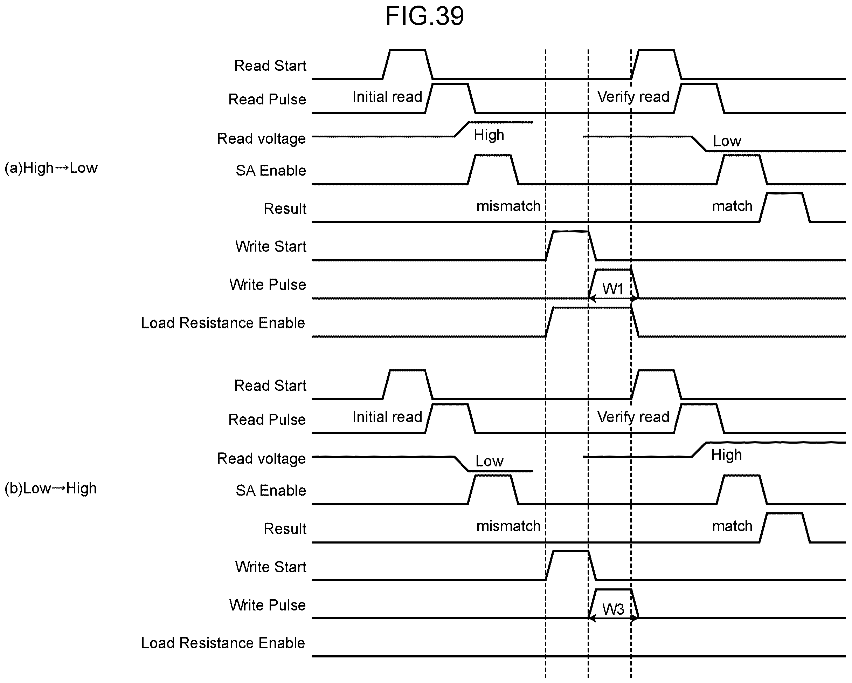

An example of a timing chart of write processing according to an eighth embodiment will be described with reference to FIG. 39. FIG. 39 is a timing chart illustrating the write processing according to the eighth embodiment. The eighth embodiment is basically the same as the fifth embodiment. The difference (write processing) therebetween will be described here.

Although, in the eighth embodiment, the first embodiment is combined with Non Patent Literature, no initialization is performed. In the first embodiment, pulse control of write from a high resistance to a low resistance is facilitated by using a load resistor (e.g., fixed resistors R1 and R2). In Non Patent Literature, pulse control of write from a low resistance to a high resistance is facilitated by using a magnetic field in the perpendicular direction. Pulse control in both directions is facilitated by the combination thereof.

In (a) of FIG. 39, data "Low" is written. In (b) of FIG. 39, data "High" is written. Here, (a) of FIG. 39 is the same as (a) of FIG. 26 described above. Furthermore, (b) of FIG. 39 is different from (b) of FIG. 26 described above in that the voltage V having the pulse width W3 is applied in a case where the resistance value R is switched from the low resistance value R_{L} to the high resistance value R_{H}. The application of the voltage V having the short pulse width W2 as in (b) of FIG. 26 is unnecessary.

In the eighth embodiment, initial read is performed, and the resistance value R of the magnetoresistive element 11 is switched between the low resistance value R_{L} and the high resistance value R_{H} as necessary. For example, when the data "High" described above is written, the constant voltage V (pulse width W3) is applied to the magnetoresistive element 11, and the resistance value R of the magnetoresistive element 11 is switched from the low resistance value R_{L} to the high resistance value R_{H}.

### <9. Functions/Effects According to Each Embodiment>

As described above, according to each embodiment, the storage device 100 includes the magnetoresistive element 11, the selection element 12, and the write circuit 24. The magnetoresistive element 11 has a variable resistance value. The selection element 12 is connected to the magnetoresistive element 11. The write circuit 24 includes the load resistance circuit 241 having a variable resistance value, and applies the voltage V to the magnetoresistive element 11 via the load resistance circuit 241. This enables data to be accurately written to the magnetoresistive element 11 by changing the resistance value of the load resistance circuit 241 and applying the voltage V to the magnetoresistive element 11 via the load resistance circuit 241. Therefore, initial read is made unnecessary. A write time can be shortened, and power consumption can be lowered. Even when initial read is made unnecessary, no erroneous write occurs, which can improve write accuracy.

Furthermore, the load resistance circuit 241 may include a plurality of fixed resistors (e.g., fixed resistors R1, R2, R2a, and R2b) having fixed and different resistance values, and a switch (e.g., switch SW1 or SW2) that switches a plurality of wiring paths passing through the fixed resistors. This can achieve the load resistance circuit 241 having a simple configuration.

Furthermore, the plurality of fixed resistors may include the fixed resistors R1 and R2. When the resistance value R of the magnetoresistive element 11 is set to the high resistance value R_{H}, the write circuit 24 may apply the voltage V to the magnetoresistive element 11 via the fixed resistor R1. When the resistance value R of the magnetoresistive element 11 is set to the low resistance value R_{L}, the write circuit 24 may apply the voltage V to the magnetoresistive element 11 via the fixed resistor R2. This can reliably improve the write accuracy.

Furthermore, the fixed resistor R1 may have a resistance value smaller than that of the fixed resistor R2. This can reliably improve the write accuracy.

Furthermore, the plurality of fixed resistors may include the fixed resistors R1, R2a, and R2b. When the resistance value R of the magnetoresistive element 11 is set to the high resistance value R_{H}, the write circuit 24 may apply the voltage V to the magnetoresistive element 11 via the fixed resistor R1. When the resistance value R of the magnetoresistive element 11 is set to the low resistance value R_{L}, the write circuit 24 may apply the voltage V to the magnetoresistive element 11 via the fixed resistor R2a, and apply the voltage V to the magnetoresistive element 11 via the fixed resistor R2b without the fixed resistor R2a in the middle of supplying the voltage V via the fixed resistor R2a. This can reliably improve the write accuracy.

Furthermore, the fixed resistor R1 may have a resistance value smaller than that of the fixed resistor R2b, and the fixed resistor R2a may have a resistance value larger than that of the fixed resistor R2b. This can reliably improve the write accuracy.

Furthermore, the load resistance circuit 241 may include the variable resistor R3 having a variable resistance value. This can achieve the load resistance circuit 241 having a simple configuration.

Furthermore, when the resistance value R of the magnetoresistive element 11 is set to the high resistance value R_{H}, the write circuit 24 may apply the voltage V to the magnetoresistive element 11 via the variable resistor R3 having a first resistance value. When the resistance value R of the magnetoresistive element 11 is set to the low resistance value R_{L}, the write circuit 24 may apply the voltage to the magnetoresistive element 11 via the variable resistor R3 having a second resistance value. This can reliably improve the write accuracy.

Furthermore, the first resistance value may be smaller than the second resistance value. This can reliably improve the write accuracy.

Furthermore, when the resistance value R of the magnetoresistive element 11 is set to the high resistance value R_{H}, the write circuit 24 may apply the voltage V to the magnetoresistive element 11 via the variable resistor R3 having the first resistance value. When the resistance value R of the magnetoresistive element 11 is set to the low resistance value R_{L}, the write circuit 24 may apply the voltage to the magnetoresistive element 11 via the variable resistor R3 having the second resistance value, and apply the voltage V to the magnetoresistive element 11 via the variable resistor R3 having a third resistance value without the variable resistor R3 having the second resistance value in the middle of supplying the voltage V via the variable resistor R3 having the second resistance value. This can reliably improve the write accuracy.

Furthermore, the first resistance value may be smaller than the third resistance value, and the second resistance value may be larger than the third resistance value. This can reliably improve the write accuracy.

Furthermore, the load resistance circuit 241 may include the fixed resistor R4 having a fixed resistance value and one or both of the two switches SW3a and SW3b that switch between the wiring path passing through the fixed resistor R4 and the wiring path not passing through the fixed resistor R4. This can achieve the load resistance circuit 241 having a simple configuration.

Furthermore, when the resistance value R of the magnetoresistive element 11 is set to the high resistance value R_{H} or the low resistance value R_{L}, the write circuit 24 may apply the voltage V to the magnetoresistive element 11 via the fixed resistor R4. This can reliably improve the write accuracy.

Furthermore, the write circuit 24 may divide the voltage V by using the load resistance circuit 241, and apply the voltage V to the magnetoresistive element 11. This can reliably improve the write accuracy.

Furthermore, the load resistance circuit 241 may be connected to the side opposite to the side of the selection element 12 of the magnetoresistive element 11. This can reliably improve the write accuracy.

Furthermore, the voltage V may be a pulse voltage. The pulse voltage may have a pulse width of 0.1 ns or more and 20 ns or less. This can reduce the write error rate, and reliably improve the write accuracy.

Furthermore, the voltage V may be a pulse voltage. The write circuit 24 may perform write by repeating application of the pulse voltage one or more times. This can reduce the write error rate, and reliably improve the write accuracy.

Furthermore, the pulse voltage may have a pulse width different for each application of the pulse voltage. This can reduce the write error rate, and reliably improve the write accuracy.

### <10. Other Embodiments>

The configurations and the pieces of processing according to the above-described embodiments (examples and variations) may be performed in various different forms other than the above-described embodiments. For example, the configurations and the pieces of processing are not limited to the above-described examples, and may be achieved in various modes. Furthermore, the configurations, the processing procedures, specific names, and information including various pieces of data and parameters in the above document and drawings can be optionally changed unless otherwise specified. For example, various pieces of information in each figure are not limited to the illustrated information.

Furthermore, the configurations and the pieces of processing according to the above-described embodiments (examples and variations) are not necessarily required to be physically configured as illustrated. That is, the specific form of distribution/integration of each device is not limited to the illustrated one, and all or part thereof can be configured in a functionally or physically distributed/integrated manner in any unit in accordance with various loads and use situations.

Furthermore, the configurations and the pieces of processing according to the above-described embodiments (examples and variations) may be appropriately combined. For example, at least a part of an embodiment may be appropriately combined with at least a part of another embodiment. Furthermore, the effects in the embodiments are merely examples and not limitations. Other effects may be exhibited.

### <11. Configuration Example of Electronic equipment>

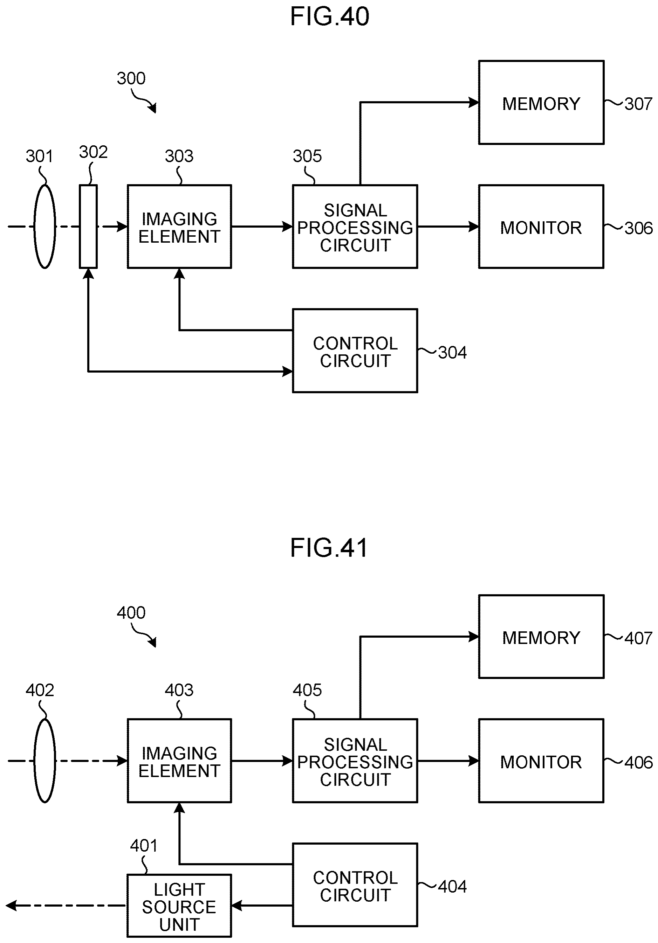

As an electronic equipment to which the storage device 100 according to the above embodiment (including modifications) is applied, an imaging device 300 and a distance measuring device 400 will be described with reference to FIGS. 40 to 41. For example, each of the imaging device 300 and the distance measuring device 400 uses the storage device 100 according to each of the above embodiments as a memory. Examples of the memory include a flash memory and the like.

### <11-1. Imaging Device >

The imaging device 300 to which the storage device 100 according to the above embodiment is applied will be described with reference to FIG. 40. FIG. 40 is a diagram illustrating an example of a schematic configuration of the imaging device 300. The imaging device 300 is an example of the electronic equipment to which the storage device 100 according to the present embodiment is applied. Examples of the imaging device 300 include electronic devices such as a digital still camera, a video camera, a smartphone having an imaging function, and a mobile phone.

As illustrated in FIG. 40, the imaging device 300 includes an optical system 301, a shutter device 302, an imaging element (a solid-state imaging device) 303, a control circuit (drive circuit) 304, a signal processing circuit 305, a monitor 306, and a memory 307. The imaging device 300 can capture a still image and a moving image.

The optical system 301 includes one or a plurality of lenses. The optical system 301 guides light (incident light) from a subject to the imaging element 303 and forms an image on a light receiving surface of the imaging element 303.

The shutter device 302 is disposed between the optical system 301 and the imaging element 303. The shutter device 302 controls a light irradiation period and a light shielding period with respect to the imaging element 303 according to the control of the control circuit 304.

The imaging element 303 accumulates signal charges for a certain period according to light formed on the light receiving surface via the optical system 301 and the shutter device 302. The signal charges accumulated in the imaging element 303 is transferred in accordance with a drive signal (timing signal) supplied from the control circuit 304.

The control circuit 304 outputs the drive signal for controlling a transfer operation of the imaging element 303 and a shutter operation of the shutter device 302 to drive the imaging element 303 and the shutter device 302.

The signal processing circuit 305 performs various types of signal processing on the signal charges output from the imaging element 303. An image (image data) obtained by performing the signal processing by the signal processing circuit 305 is supplied to the monitor 306 and also supplied to the memory 307.

The monitor 306 displays a moving image or a still image captured by the imaging element 303 based on the image data supplied from the signal processing circuit 305. As the monitor 306, for example, a panel type display device such as a liquid crystal panel or an organic electro luminescence (EL) panel is used.

The memory 307 stores the image data supplied from the signal processing circuit 305, that is, image data of the moving image or the still image captured by the imaging element 303. The memory 307 corresponds to the storage device 100 according to the above embodiment.

Also in the imaging device 300 configured in this manner, the data write accuracy can be improved by using the above-described storage device 100 as the memory 307.

### <11-2. Distance Measuring Device>

The distance measuring device 400 to which the storage device 100 according to the above embodiment is applied will be described with reference to FIG. 41. FIG. 41 is a diagram illustrating an example of a schematic configuration of the distance measuring device 400. The distance measuring device 400 is an example of the electronic equipment to which the storage device 100 according to the present embodiment is applied.

As illustrated in FIG. 41, the distance measuring device (distance image sensor) 400 includes a light source unit 401, an optical system 402, an imaging element (a solid-state imaging device) 403, a control circuit (drive circuit) 404, a signal processing circuit 405, a monitor 406, and a memory 407. The distance measuring device 400 can acquire a distance image according to a distance to a subject by projecting light from the light source unit 401 toward the subject and receiving light (modulated light or pulsed light) reflected from a surface of the subject.

The light source unit 401 projects light toward the subject. As the light source unit 401, for example, a vertical cavity surface emitting laser (VCSEL) array that emits laser light as a surface light source or a laser diode array in which laser diodes are arrayed on a line is used. Note that the laser diode array is supported by a predetermined drive unit (not illustrated), and is scanned in a direction perpendicular to the array direction of the laser diodes.

The optical system 402 includes one or a plurality of lenses. The optical system 402 guides light (incident light) from the subject to the imaging element 403 to form an image on a light receiving surface (sensor unit) of the imaging element 403.

The imaging element 403 stores signal charges according to the light of the image formed on the light receiving surface via the optical system 402. A distance signal indicating the distance obtained from a light reception signal (APD OUT) output from the imaging element 403 is supplied to the signal processing circuit 405. As the imaging element 403, for example, a solid-state imaging element such as an image sensor is used.

The control circuit 404 outputs a drive signal (control signal) for controlling operations of the light source unit 401, the imaging element 403, and the like to drive the light source unit 401, the imaging element 403, and the like.

The signal processing circuit 405 performs various types of signal processing on the distance signal supplied from the imaging element 403. For example, the signal processing circuit 405 performs image processing (for example, histogram processing, peak detection processing, and the like) of constructing the distance image on the basis of the distance signal. An image (image data) obtained by performing the signal processing by the signal processing circuit 405 is supplied to the monitor 406 and also supplied to the memory 407.

The monitor 406 displays the distance image captured by the imaging element 403 on the basis of the image data supplied from the signal processing circuit 405. As the monitor 406, for example, a panel type display device such as a liquid crystal panel or an organic EL panel is used.

The memory 407 stores the image data supplied from the signal processing circuit 405, that is, the image data of the distance image captured by the imaging element 403. The memory 407 corresponds to the storage device 100 according to the above embodiment.

Also in the distance measuring device 400 configured in this manner, the data write accuracy can be improved by using the above-described storage device 100 as the memory 407.

It is noted that the storage device 100 according to the above embodiment may be mounted on the same semiconductor chip together with a semiconductor circuit forming an arithmetic device or the like to form a semiconductor device (System-on-a-Chip: SoC).

Furthermore, the storage device 100 according to the above embodiment can be mounted on various electronic devices on which a memory (storage unit) can be mounted as described above. For example, the storage device 100 may be mounted on various electronic devices such as a game device, a notebook personal computer (PC), a mobile device (for example, a smartphone, a tablet PC, or the like), a personal digital assistant (PDA), a wearable device, and a music device in addition to the imaging device 300 and the distance measuring device 400. For example, the storage device 100 is used as various memories such as a storage.

### <12. Appendix>

Note that the present technology can also have the configurations as follows.
(1) A storage device comprising:
   a magnetoresistive element having a variable resistance value;
   a selection element connected to the magnetoresistive element; and
   a write circuit that includes a load resistance circuit having a variable resistance value and applies a voltage to the magnetoresistive element via the load resistance circuit.
(2) The storage device according to (1),
   wherein the load resistance circuit includes:
   a plurality of fixed resistors having fixed and different resistance values; and
   a switch that switches a plurality of wiring paths passing through the plurality of fixed resistors.
(3) The storage device according to (2),
   wherein the plurality of fixed resistors includes a first fixed resistor and a second fixed resistor, and
   when a resistance value of the magnetoresistive element is set to a high resistance value, the write circuit applies the voltage to the magnetoresistive element via the first fixed resistor, and
   when a resistance value of the magnetoresistive element is set to a low resistance value, the write circuit applies the voltage to the magnetoresistive element via the second fixed resistor.
(4) The storage device according to (3),
   wherein the first fixed resistor has a resistance value smaller than a resistance value of the second fixed resistor.
(5) The storage device according to (2),
   wherein the plurality of fixed resistors includes a first fixed resistor, a second fixed resistor, and a third fixed resistor, and
   when a resistance value of the magnetoresistive element is set to a high resistance value, the write circuit applies the voltage to the magnetoresistive element via the first fixed resistor, and
   when a resistance value of the magnetoresistive element is set to a low resistance value, the write circuit applies the voltage to the magnetoresistive element via the second fixed resistor, and applies the voltage to the magnetoresistive element via the third fixed resistor without the second fixed resistor in middle of supplying the voltage via the second fixed resistor.
(6) The storage device according to (5),
   wherein the first fixed resistor has a resistance value smaller than a resistance value of the third fixed resistor, and
   the second fixed resistor has a resistance value larger than a resistance value of the third fixed resistor.
(7) The storage device according to (1),
   wherein the load resistance circuit includes a variable resistor having a variable resistance value.
(8) The storage device according to (7),
   wherein, when a resistance value of the magnetoresistive element is set to a high resistance value, the write circuit applies the voltage to the magnetoresistive element via the variable resistor having a first resistance value, and
   when a resistance value of the magnetoresistive element is set to a low resistance value, the write circuit applies the voltage to the magnetoresistive element via the variable resistor having a second resistance value.
(9) The storage device according to (8),
   wherein the first resistance value is smaller than the second resistance value.
(10) The storage device according to (7),
   wherein, when a resistance value of the magnetoresistive element is set to a high resistance value, the write circuit applies the voltage to the magnetoresistive element via the variable resistor having a first resistance value, and
   when a resistance value of the magnetoresistive element is set to a low resistance value, the write circuit applies the voltage to the magnetoresistive element via the variable resistor having a second resistance value, and applies the voltage to the magnetoresistive element via the variable resistor having a third resistance value without the variable resistor having a second resistance value in middle of supplying the voltage via the variable resistor having a second resistance value.
(11) The storage device according to (10),
   wherein the first resistance value is smaller than the third resistance value, and
   the second resistance value is larger than the third resistance value.
(12) The storage device according to (1),
   wherein the load resistance circuit includes:
   a fixed resistor having a fixed resistance value; and
   a switch that switches between a wiring path passing through the fixed resistor and a wiring path not passing through the fixed resistor.
(13) The storage device according to (12),
   wherein, when a resistance value of the magnetoresistive element is set to a high resistance value or a low resistance value, the write circuit applies the voltage to the magnetoresistive element via the fixed resistor.
(14) The storage device according to any one of (1) to (13),
   wherein the write circuit divides the voltage by using the load resistance circuit, and applies the voltage to the magnetoresistive element.
(15) The storage device according to any one of (1) to (14),
   wherein the load resistance circuit is connected to a side opposite to a side of the selection element of the magnetoresistive element.
(16) The storage device according to any one of (1) to (15),
   wherein the voltage is a pulse voltage, and
   the pulse voltage has a pulse width of 0.1 ns or more and 20 ns or less.
(17) The storage device according to any one of (1) to (16),
   wherein the voltage is a pulse voltage, and
   the write circuit performs write by repeating application of the pulse voltage one or more times.
(18) The storage device according to (17),
   wherein the pulse voltage has a pulse width different for each application of the pulse voltage.
(19) Electronic equipment comprising a storage device that stores data,
   wherein the storage device includes:
   a magnetoresistive element having a variable resistance value;
   a selection element connected to the magnetoresistive element; and
   a write circuit that includes a load resistance circuit having a variable resistance value and applies a voltage to the magnetoresistive element via the load resistance circuit.
(20) A method of controlling a storage device comprising controlling a storage device including: a magnetoresistive element having a variable resistance value; and a selection element connected to the magnetoresistive element,
   wherein a write circuit applies a voltage to the magnetoresistive element via a load resistance circuit having a variable resistance value.
(21) Electronic equipment including the storage device according to any one of (1) to (18).
(22) A method of controlling a storage device, comprising controlling the storage device according to any one of (1) to (18).

### Reference Signs List

1 MEMORY CELL ARRAY
10 MEMORY CELL
11 MAGNETORESISTIVE ELEMENT
12 SELECTION ELEMENT
21 I/O
22 CONTROL CIRCUIT
23 VOLTAGE GENERATION CIRCUIT
24 WRITE CIRCUIT
25 READ CIRCUIT
26 BIT LINE ADDRESS DECODER
27 BIT LINE CONTROL CIRCUIT
28 WORD LINE ADDRESS DECODER
29 WORD LINE CONTROL CIRCUIT
30 SENSE AMPLIFIER
100 STORAGE DEVICE
111 FIXED LAYER
112 TUNNEL BARRIER LAYER
113 RECORDING LAYER
114 MAGNETIC FIELD GENERATION LAYER
115 MAGNETIC FIELD GENERATION LAYER
241 LOAD RESISTANCE CIRCUIT
300 IMAGING DEVICE
307 MEMORY
400 DISTANCE MEASURING DEVICE
407 MEMORY
L1 WIRING
R1 FIXED RESISTOR
R2 FIXED RESISTOR
R2a FIXED RESISTOR
R2b FIXED RESISTOR
R3 VARIABLE RESISTOR
R4 FIXED RESISTOR
SW1 SWITCH
SW2 SWITCH
SW3a SWITCH
SW3b SWITCH
BL BIT LINE
SL SOURCE LINE
WL WORD LINE

## Claims

1. A storage device comprising:
a magnetoresistive element having a variable resistance value;
a selection element connected to the magnetoresistive element; and
a write circuit that includes a load resistance circuit having a variable resistance value and applies a voltage to the magnetoresistive element via the load resistance circuit.

2. The storage device according to claim 1,
wherein the load resistance circuit includes:
a plurality of fixed resistors having fixed and different resistance values; and
a switch that switches a plurality of wiring paths passing through the plurality of fixed resistors.

3. The storage device according to claim 2,
wherein the plurality of fixed resistors includes a first fixed resistor and a second fixed resistor, and
when a resistance value of the magnetoresistive element is set to a high resistance value, the write circuit applies the voltage to the magnetoresistive element via the first fixed resistor, and
when a resistance value of the magnetoresistive element is set to a low resistance value, the write circuit applies the voltage to the magnetoresistive element via the second fixed resistor.

4. The storage device according to claim 3,
wherein the first fixed resistor has a resistance value smaller than a resistance value of the second fixed resistor.

5. The storage device according to claim 2,
wherein the plurality of fixed resistors includes a first fixed resistor, a second fixed resistor, and a third fixed resistor, and
when a resistance value of the magnetoresistive element is set to a high resistance value, the write circuit applies the voltage to the magnetoresistive element via the first fixed resistor, and
when a resistance value of the magnetoresistive element is set to a low resistance value, the write circuit applies the voltage to the magnetoresistive element via the second fixed resistor, and applies the voltage to the magnetoresistive element via the third fixed resistor without the second fixed resistor in middle of supplying the voltage via the second fixed resistor.

6. The storage device according to claim 5,
wherein the first fixed resistor has a resistance value smaller than a resistance value of the third fixed resistor, and
the second fixed resistor has a resistance value larger than a resistance value of the third fixed resistor.

7. The storage device according to claim 1,
wherein the load resistance circuit includes a variable resistor having a variable resistance value.

8. The storage device according to claim 7,
wherein, when a resistance value of the magnetoresistive element is set to a high resistance value, the write circuit applies the voltage to the magnetoresistive element via the variable resistor having a first resistance value, and
when a resistance value of the magnetoresistive element is set to a low resistance value, the write circuit applies the voltage to the magnetoresistive element via the variable resistor having a second resistance value.

9. The storage device according to claim 8,
wherein the first resistance value is smaller than the second resistance value.

10. The storage device according to claim 7,
wherein, when a resistance value of the magnetoresistive element is set to a high resistance value, the write circuit applies the voltage to the magnetoresistive element via the variable resistor having a first resistance value, and
when a resistance value of the magnetoresistive element is set to a low resistance value, the write circuit applies the voltage to the magnetoresistive element via the variable resistor having a second resistance value, and applies the voltage to the magnetoresistive element via the variable resistor having a third resistance value without the variable resistor having a second resistance value in middle of supplying the voltage via the variable resistor having a second resistance value.

11. The storage device according to claim 10,
wherein the first resistance value is smaller than the third resistance value, and
the second resistance value is larger than the third resistance value.

12. The storage device according to claim 1,
wherein the load resistance circuit includes:
a fixed resistor having a fixed resistance value; and
a switch that switches between a wiring path passing through the fixed resistor and a wiring path not passing through the fixed resistor.

13. The storage device according to claim 12,
wherein, when a resistance value of the magnetoresistive element is set to a high resistance value or a low resistance value, the write circuit applies the voltage to the magnetoresistive element via the fixed resistor.

14. The storage device according to claim 1,
wherein the write circuit divides the voltage by using the load resistance circuit, and applies the voltage to the magnetoresistive element.

15. The storage device according to claim 1,
wherein the load resistance circuit is connected to a side opposite to a side of the selection element of the magnetoresistive element.

16. The storage device according to claim 1,
wherein the voltage is a pulse voltage, and
the pulse voltage has a pulse width of 0.1 ns or more and 20 ns or less.

17. The storage device according to claim 1,
wherein the voltage is a pulse voltage, and
the write circuit performs write by repeating application of the pulse voltage one or more times.

18. The storage device according to claim 17,
wherein the pulse voltage has a pulse width different for each application of the pulse voltage.

19. Electronic equipment comprising a storage device that stores data,
wherein the storage device includes:
a magnetoresistive element having a variable resistance value;
a selection element connected to the magnetoresistive element; and
a write circuit that includes a load resistance circuit having a variable resistance value and applies a voltage to the magnetoresistive element via the load resistance circuit.

20. A method of controlling a storage device comprising controlling a storage device including: a magnetoresistive element having a variable resistance value; and a selection element connected to the magnetoresistive element,
wherein a write circuit applies a voltage to the magnetoresistive element via a load resistance circuit having a variable resistance value.
